(19) Europäisches Patentamt
European Patent Office
Office européen des brevets

(11) **EP 3 360 031 B1**

(12) **FASCICULE DE BREVET EUROPEEN**

(45) Date de publication et mention de la délivrance du brevet:
**04.09.2019 Bulletin 2019/36**

(21) Numéro de dépôt: **16791654.3**

(22) Date de dépôt: **07.10.2016**

(51) Int Cl.:
***G06F 3/046*** *(2006.01)*

(86) Numéro de dépôt international:
**PCT/FR2016/052591**

(87) Numéro de publication internationale:
**WO 2017/060644 (13.04.2017 Gazette 2017/15)**

(54) **PROCÉDÉ DE SUIVI D'UNE POSITION D'UN AIMANT PAR MESURE DIFFÉRENTIELLE**

VERFAHREN ZUR VERFOLGUNG EINER POSITION EINES MAGNETEN DURCH DIFFERENZMESSUNG

METHOD OF TRACKING A POSITION OF A MAGNET BY DIFFERENTIAL MEASUREMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.10.2015 FR 1559642**

(43) Date de publication de la demande:
**15.08.2018 Bulletin 2018/33**

(73) Titulaire: **ISKN**
**38400 Saint-Martin-D'Hères (FR)**

(72) Inventeur: **HAUTSON, Tristan**
**38600 Fontaine (FR)**

(74) Mandataire: **GIE Innovation Competence Group**
**310, avenue Berthelot**
**69372 Lyon Cedex 08 (FR)**

(56) Documents cités:
**WO-A1-2009/007210      WO-A2-2013/144337**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

## DOMAINE TECHNIQUE

L'invention concerne un dispositif de suivi d'une position d'un aimant, relativement à une pluralité de magnétomètres, en estimant les positions successivement occupées par l'aimant par rapport à ce réseau. Une application possible est le report, sur un écran, ou sur un fichier informatique, de ladite position.

## ART ANTERIEUR

La détermination de la position et de l'orientation d'un aimant par rapport à un réseau de magnétomètres a été décrite dans la demande WO2013144337. Dans ce document, il est expliqué comment, à partir d'une pluralité de mesures d'un champ magnétique induit par l'aimant, il est possible de déterminer la position et l'orientation de ce dernier. Plus précisément, on met en oeuvre un dispositif comportant un réseau de magnétomètres, dont la position est connue. Chaque magnétomètre est apte à mesurer une composante d'un champ magnétique généré par l'aimant, selon au moins un axe de mesure. La combinaison de différentes mesures, issues de différents magnétomètres, permet de déterminer la position, et éventuellement, l'orientation de l'aimant, par rapport au réseau de magnétomètres.

Une application possible de ce procédé est la réalisation d'une ardoise magnétique, dans laquelle les magnétomètres sont agencés selon un réseau sensiblement plan, et parallèle à une surface d'appui de l'ardoise. Un utilisateur peut alors déplacer un crayon, comportant un aimant, de façon à former une inscription sur un support d'écriture, par exemple un support papier, ce dernier étant disposé contre ladite surface d'appui. Le procédé permet alors un suivi de la trajectoire de l'aimant. Ainsi, l'inscription formée par l'utilisateur contre la surface d'appui peut être enregistrée par l'ardoise magnétique, puis reportée sur un écran et/ou mémorisée.

Le document WO2009/007210 décrit un procédé pour déterminer une orientation d'un aimant par rapport à un réseau de magnétomètres. Pour cela, le champ magnétique mesuré par chaque magnétomètre est comparé à une valeur de référence, cette dernière correspondant à une mesure, ou une estimation, du champ magnétique mesuré par le magnétomètre lorsque l'aimant présente une orientation prédéterminée. Sur chaque magnétomètre, on détermine une valeur de référence correspondant à différentes orientations prédéterminées de l'aimant. La mise en oeuvre de ce procédé est simple, puisqu'elle consiste en une simple comparaison entre le champ magnétique mesuré par chaque magnétomètre et les valeurs de références préalablement déterminées. Cependant, l'orientation mesurée par le procédé ne peut correspondre qu'à une desdites orientations prédéterminées.

Les inventeurs ont cherché à perfectionner le procédé décrit dans WO2013144337. En effet, ce procédé suppose la mise en place d'une initialisation, au cours de laquelle pour chaque magnétomètre, la mesure du champ magnétique produit par l'aimant doit être négligeable. Aussi, lors de cette initialisation, chaque magnétomètre mesure un signal d'ambiance, correspondant sensiblement au champ magnétique ambiant de l'environnement dans lequel est placé le dispositif. La mesure de chaque magnétomètre est également affectée d'un signal d'offset, propre au capteur. Ce signal peut être dû à des effets de magnétisation du capteur, ou à la fluctuation de certains composants, par exemple les magnétorésistances. Lors du déroulement du procédé, on soustrait un signal d'ambiance et un signal d'offset, déterminés à un instant initial, des mesures effectuées par chaque magnétomètre. Or, le signal d'offset et, dans une moindre mesure, le signal d'ambiance, peuvent fluctuer au cours du temps, ce qui entraîne une dérive du signal mesuré par chaque magnétomètre. Il en résulte un biais non maîtrisé dans la mesure du champ magnétique généré par l'aimant, pouvant entraîner une erreur d'estimation de la position de l'aimant.

De plus, le processus d'initialisation peut être contraignant, car il impose de placer l'aimant à une distance suffisante du réseau de magnétomètres, de telle sorte que le champ magnétique qu'il produit n'influence pas les mesures des magnétomètres. Par exemple, un aimant dont le moment magnétique s'élève à 0.2 A.m$^2$ est disposé à une distance d'environ 30 cm des magnétomètres, de telle sorte que le champ magnétique produit par l'aimant au niveau des magnétomètres soit négligeable par rapport au champ magnétique ambiant.

L'invention permet de résoudre ces inconvénients, en permettant une détermination plus précise de la position de l'aimant, et permettant de réinitialiser le procédé plus régulièrement, voire à considérer simultanément plusieurs initialisations.

## EXPOSE DE L'INVENTION

L'invention est décrite dans les revendications indépendantes. Les modes de réalisation préférés sont décrits dans les revendications dépendantes.

Un premier objet de l'invention est un procédé d'estimation de la position d'un aimant, ledit aimant étant déplacé relativement à un réseau de magnétomètres, comprenant une pluralité de magnétomètres, chaque magnétomètre étant apte à mesurer un champ magnétique généré par ledit aimant, selon au moins un axe de mesure, le procédé comportant les étapes suivantes :

a) mesure, par chaque magnétomètre, d'un champ magnétique de référence, à un instant de référence ;

b) affectation d'une position de référence de l'aimant audit instant de référence ;

c) mesure d'un champ magnétique généré par ledit aimant, par chaque magnétomètre, à un instant de mesure postérieur à l'instant de référence ;

d) calcul d'un champ magnétique différentiel, représentant une différence, pour chaque magnétomètre, entre le champ magnétique mesuré à l'étape c) et le champ magnétique de référence mesuré à l'étape a);

e) à partir de chaque champ magnétique différentiel, et d'une estimation de ladite position de référence, estimation d'une position dudit aimant audit instant de mesure ;

f) réitération des étapes c) à e), sur la base de l'estimation de l'étape e), en incrémentant l'instant de mesure.

Lors de la première itération, la position de référence peut notamment être la position de référence affectée à l'aimant à l'instant de référence. Elle est soit connue, soit déterminée arbitrairement.

Le procédé peut comporter, lors de l'étape e), une estimation de la position de l'aimant à partir :

- d'une estimation de la position de l'aimant à un instant précédent l'instant de mesure ;
- d'une estimation de la position de référence, ladite estimation étant réalisée à un instant précédent l'instant de mesure ;

l'étape e) comprenant également une estimation de la position de référence, audit instant de mesure.

Le procédé peut comporter, suite à l'étape e), une étape e') de validation des estimations respectives de la position de l'aimant à l'instant de mesure et de la position de référence, cette étape comportant les sous-étapes suivantes :

i) détermination d'un déplacement de l'aimant entre l'instant de mesure et l'instant de référence, en pondérant à chacun de ces instants, une position de chaque magnétomètre par un facteur de pondération dépendant du module du champ magnétique mesuré par ledit magnétomètre audit instant ;

ii) comparaison du déplacement déterminé lors de la sous-étape i) avec un déplacement calculé selon les estimations, à l'instant de mesure, de la position de l'aimant et de la position de référence.

La sous-étape i) peut comprendre :

- la détermination, pour chaque magnétomètre, d'un champ magnétique différentiel dit instantané, représentant une variation entre le champ magnétique mesuré à un premier instant et le champ magnétique mesuré à un deuxième instant, ledit deuxième instant étant voisin dudit premier instant, ladite détermination étant réalisée en considérant successivement un premier instant correspondant à l'instant de mesure et à l'instant de référence, de façon à obtenir un champ magnétique différentiel instantané à chacun de ces instants ;
- ladite détermination de chaque facteur de pondération, à l'instant de mesure et à l'instant de référence, étant effectuée respectivement à partir du module du champ magnétique différentiel instantané, respectivement à l'instant de mesure et à l'instant de référence.

Selon un mode de réalisation :

- les étapes a) et b) sont répétées, de telle sorte qu'on dispose d'une pluralité de positions de référence, à chaque position de référence étant associés :

  - un instant de référence ;
  - une affectation de la position de l'aimant audit instant de référence ;
  - une mesure du champ magnétique, par chaque magnétomètre, audit instant de référence ;

- l'étape d) comporte le calcul d'au moins un champ magnétique différentiel, à partir d'au moins un champ magnétique de référence.

Selon ce mode de réalisation :

- chaque position de référence peut être associée à un indicateur de validité, conditionnant la prise en compte de ladite position de référence, à chaque instant de mesure, lors des étapes d) et e) ;
- les étapes a) et b) peuvent être répétées lorsque le nombre de positions de référence est inférieur à un nombre prédéterminé de positions de référence.

- l'étape d) peut comprendre le calcul d'une pluralité de champs magnétiques différentiels, représentant chacun une différence, pour chaque magnétomètre, entre le champ magnétique mesuré à l'étape c) et chaque champ magnétique de référence. L'étape e) peut alors comprendre une pluralité d'estimations, dites intermédiaires, de la position dudit aimant audit instant de mesure, chaque estimation intermédiaire étant basée sur une position de référence différente l'une de l'autre, la position de l'aimant audit instant de mesure étant déterminée en fonction de ces estimations intermédiaires. Elle peut également comprendre une mise à jour de l'estimation de chaque position de référence à chaque instant de mesure. La position de l'aimant à l'instant de mesure peut alors être estimée :

  ▪ à partir d'une moyenne desdites estimations intermédiaires, éventuellement pondérée ;
  ▪ en considérant la position de référence la plus éloignée, ou une position de référence située au-delà d'une distance prédéterminée, de la pluralité d'estimations intermédiaires ;
  ▪ sur la base d'une position de référence sélectionnée en fonction de l'indicateur de validité qui lui est associé ;
  ▪ en considérant successivement chaque position de référence de ladite pluralité de positions de référence.

Le procédé peut comporter l'une des caractéristiques suivantes, prises isolément ou selon les combinaisons techniquement réalisables :

- lors de l'étape b), à ladite position de référence est affectée soit une position arbitraire, soit une estimation de la position de l'aimant à l'instant de référence ;
- l'étape e) comporte, outre une estimation de la position de l'aimant à chaque instant de mesure, une estimation d'une orientation de l'aimant à cet instant ;
- l'étape e) comporte également une estimation de composantes d'un moment magnétique de l'aimant à l'instant de mesure. Ces composantes peuvent conditionnées, de telle sorte que le module du champ magnétique de l'aimant corresponde à une valeur, ou une plage de valeur, prédéterminée.

Selon un mode de réalisation, l'étape e) comporte une détermination d'un vecteur d'état, relatif à l'instant de mesure, ce vecteur d'état étant déterminé en fonction dudit vecteur d'état à un instant précédent l'instant de mesure : cet instant précédent peut être un instant de référence, ou un instant de mesure correspondant à une itération précédente, et en particulier l'itération précédente. Ce vecteur d'état peut notamment comporter : la position de l'aimant à l'instant de mesure, une estimation, à l'instant de mesure, d'au moins une position de référence de l'aimant, et éventuellement une estimation du moment magnétique de l'aimant à l'instant de mesure ainsi qu'à l'instant de référence. Ce vecteur d'état est actualisé à chaque itération des étapes c), d) et e), l'étape e) pouvant alors comporter :

- une sous-étape d'estimation du vecteur d'état à l'instant de mesure, sur la base d'un vecteur d'état relatif à un instant précédent l'instant de mesure, et par exemple l'instant correspondant à l'itération précédente ;
- une sous-étape de mise à jour du vecteur d'état à l'instant de mesure, sur la base du champ magnétique différentiel déterminé lors de l'étape d).

Selon un mode de réalisation, compatible avec les modes de réalisation précédemment décrits :

- l'étape d) comprend une détermination, à l'instant de mesure, d'un champ magnétique différentiel moyen, représentant une différence entre une moyenne des champs magnétiques mesurés par chaque magnétomètre respectivement à l'instant de mesure et à l'instant de référence ;
- l'étape e) comprend une prise en compte du champ magnétique différentiel moyen ainsi établi, dont les termes sont soustraits au champ magnétique différentiel.

L'étape e) peut alors comprendre :

- une estimation du champ magnétique différentiel mesuré, à l'instant de mesure, par chaque magnétomètre, ainsi qu'une détermination d'une moyenne desdites estimations ;
- une prise en compte de la moyenne des estimations de chaque champ magnétique différentiel mesuré de chaque magnétomètre, dont les termes sont soustraits à l'estimation du champ magnétique différentiel mesuré, à l'instant de mesure, par chaque magnétomètre.

Selon un mode de réalisation, lorsque plusieurs références sont utilisées, on établit une position de référence dite fusionnée. La détermination de cette position de référence fusionnée comprend les étapes suivantes :

- à partir de l'estimation, à un instant de mesure, d'une première position de référence, détermination d'un champ magnétique produit par l'aimant à l'instant de référence associé à ladite première position de référence et détermination d'un champ magnétique ambiant à cet instant de référence ;
- à partir de l'estimation, audit instant de mesure, d'une deuxième position de référence, détermination d'un champ magnétique produit par l'aimant à l'instant de référence associé à ladite deuxième position de référence et détermination d'un champ magnétique ambiant à cet instant de référence ;
- établissement d'une nouvelle position de référence, en combinant lesdits champs magnétiques ambiants ainsi établis, cette position de référence pouvant être affectée d'une position à l'infini, ou affectée un moment magnétique de référence nul.

Selon ce mode de réalisation, plusieurs positions de référence peuvent alors être fusionnées, en estimant autant de champs magnétiques ambiants à chaque instant de référence associé à une position de référence.

Quels que soient les modes de réalisations, l'étape e) peut être effectuée en utilisant un estimateur récursif, par exemple un filtre de Kalman ou un filtre de Kalman étendu.

Un autre objet de l'invention est un dispositif de localisation d'un aimant mobile, l'aimant étant apte à être déplacé relativement à un réseau de magnétomètres, chaque magnétomètre étant apte à fournir, à différents instants de mesure, une mesure d'un champ magnétique produit par ledit aimant selon au moins un axe de mesure, le dispositif comportant un processeur configuré pour recevoir, à chaque instant de mesure, les mesures fournies par chaque magnétomètre, et pour mettre en oeuvre le procédé décrit dans cette demande, de façon à déterminer une position de l'aimant à chaque instant de mesure.

L'invention sera mieux comprise à la lecture de la description qui va suivre, donnée à titre d'exemple non limitatif et se référant aux figures présentées ci-dessous.

## FIGURES

La figure 1A représente un châssis comprenant des magnétomètres formant un réseau.

La figure 1B représente une vue en perspective de ce châssis, ainsi qu'un aimant dont on cherche à déterminer la position et éventuellement l'orientation par rapport au réseau de magnétomètres.

La figure 2A représente les principales étapes d'un mode de réalisation de l'invention.

La figure 2B représente le détail d'une des étapes de la figure 2A.

La figure 3A représente les principales étapes d'une variante du mode de réalisation représenté sur la figure 2A.

Les figures 3B et 3C sont des illustrations de la variante décrite en lien avec la figure 3A.

La figure 4A représente les principales étapes d'un autre mode de réalisation de l'invention.

La figure 4B représente le détail d'une des étapes de cet autre mode de réalisation.

Dans ces figures, les mêmes références sont utilisées pour désigner les mêmes éléments.

## EXPOSE DE MODES DE REALISATION PARTICULIERS

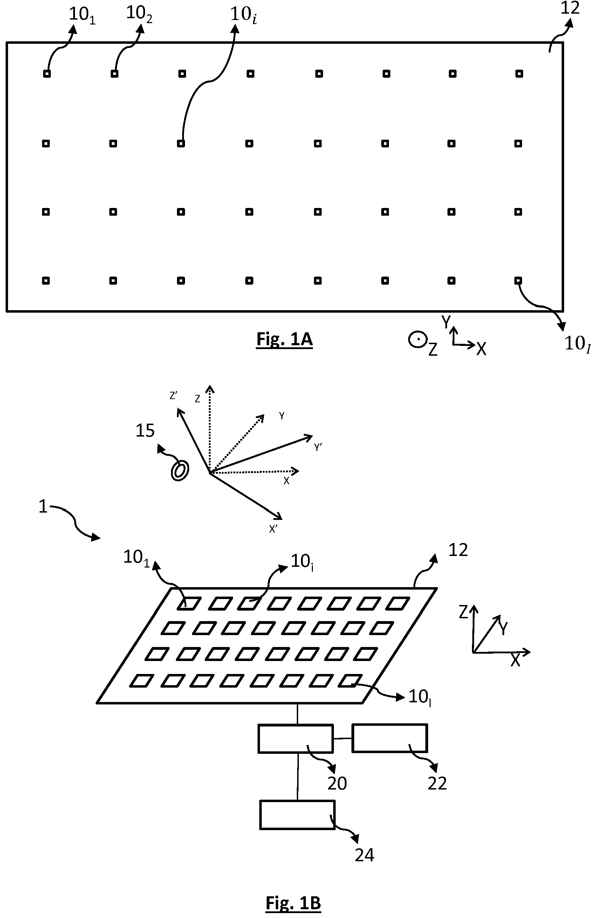

La figure 1A représente un châssis 12 comportant un réseau de magnétomètres $10_1$, $10_2$...$10_i$...$10_I$. Chaque magnétomètre est ici agencé selon un réseau matriciel. Chaque magnétomètre est repéré par l'indice $i$, tel que $1 \le i \le I$. Le réseau comporte $I$ magnétomètres, avec, dans ce cas, $I = 32$. Dans cet exemple, les magnétomètres sont coplanaires, ou sensiblement coplanaires, dans un plan défini par des axes X et Y. Chaque magnétomètre $10_i$ est apte à mesurer un champ magnétique $B_i$ auquel il est exposé, et en particulier une composante de ce champ magnétique selon au moins un axe de mesure $x_i$, $y_i$, $z_i$. Sur cette figure, on a représenté les axes X,Y,Z d'un référentiel R lié au châssis 12. De préférence, chaque magnétomètre est un magnétomètre triaxe. Dans ce cas, les axes de mesure $x_i$, $y_i$, $z_i$ de chaque magnétomètre $10_i$ peuvent être confondus aux axes de mesure du référentiel $R$. Le châssis 12 est, dans cet exemple, un châssis rigide, sur lequel sont fixés les magnétomètres. Il peut notamment s'agir d'une carte PCB (acronyme de Printed Circuit Board, signifiant circuit imprimé). Dans cet exemple, les magnétomètres sont fixes les uns par rapport aux autres, ce qui constitue une configuration préférée.

La figure 1B représente un dispositif selon l'invention, comportant le châssis 12, décrit en lien avec la figure 1A, ce dernier étant relié à un processeur 20, par exemple un microprocesseur. Le processeur 20 est relié à une mémoire 22 comportant des instructions, ces dernières pouvant être exécutées par le processeur 20, pour mettre en oeuvre le procédé décrit ci-après. Ces instructions peuvent être sauvegardées sur un support d'enregistrement, lisible par le processeur, de type disque dur, CDROM ou autre type de mémoire. Le processeur peut être relié à une unité d'affichage 24, par exemple un écran.

Sur la figure 1B est également représenté un aimant 15, apte à être déplacé relativement aux magnétomètres. Cet aimant est associé à un référentiel, dit référentiel de l'aimant, $R'$ dont les axes X', Y' et Z' sont représentés sur la figure 1B. Ce référentiel est mobile par rapport au référentiel du châssis $R$. Le moment magnétique dipolaire $\boldsymbol{m}$ généré par l'aimant peut être orienté, par rapport au référentiel $R$, selon les angles d'Euler $\psi$ (précession), $\theta$ (nutation), $\varphi$ (rotation propre), associés au passage du référentiel $R$, défini par les axes XYZ au référentiel $R'$ défini par les axes X', Y' et Z'.

L'aimant 15 peut être un aimant permanent, un électro-aimant ou un matériau ferromagnétique présentant un champ rémanent. Son moment magnétique est par exemple compris entre 0.01 A.m$^2$ et 1 A.m$^2$. Il est de préférence fixé, par une liaison rigide, à un crayon, de telle sorte que le dispositif est apte à détecter les mouvements du crayon vis-à-vis du réseau de magnétomètres. Le champ magnétique produit par cet aimant, au niveau de plusieurs magnétomètres, est de préférence, supérieur à 100 A.m$^{-1}$, ou 500 A.m$^{-1}$ de telle sorte que l'aimant puisse être « visible », c'est-à-dire détecté, par lesdits magnétomètres. L'homme du métier dimensionnera l'aimant, ainsi que les magnétomètres, de telle sorte que le champ magnétique produit par l'aimant soit détectable par chaque magnétomètre lorsque l'aimant est distant d'au moins 5 cm ou 10 cm du châssis.

Dans une application, un support d'écriture est disposé sur une surface d'appui, placée entre les magnétomètres 12 et le crayon. Le papier peut notamment s'appuyer contre la surface d'appui, de telle sorte que le dispositif est apte à enregistrer une inscription formée par le crayon sur ledit papier, à l'instar du dispositif décrit dans WO2013144337, cité en référence à l'art antérieur. Le support d'écriture peut être un papier, un carton ou une toile. Le support d'écriture est alors suffisamment fin pour que le champ magnétique généré par l'aimant puisse être détecté par une pluralité de magnétomètres formant le réseau. Un utilisateur peut alors déplacer le crayon et réaliser une inscription sur le papier, le déplacement de l'aimant étant alors suivi par le processeur 20, de façon à mémoriser l'inscription dans la mémoire 22 et/ou l'afficher sur l'écran 24.

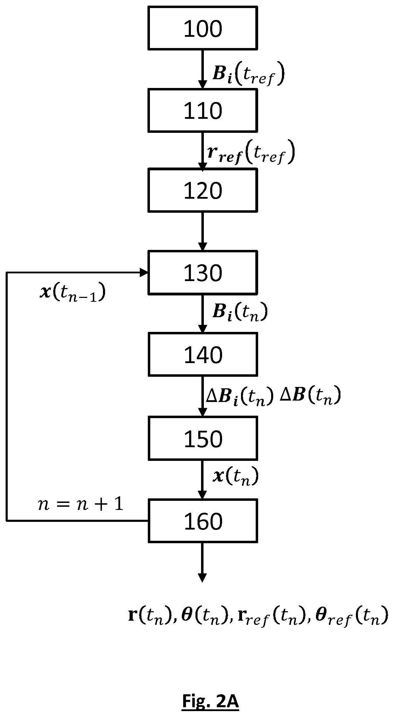

On va à présent décrire, en lien avec la figure 2A, les principales étapes d'un procédé pouvant être mis en oeuvre afin de détecter la position de l'aimant en fonction du temps, de façon à en établir une trajectoire dans le référentiel du châssis $R$. Comme précédemment évoqué, le procédé peut être mis en oeuvre par le processeur 20, ce dernier recevant les données mesurées par les magnétomètres $10_i$ du réseau. Les positions successives de l'aimant sont ensuite mémorisées dans la mémoire 22 et/ou reportée sur l'écran d'affichage 24.

Chaque magnétomètre est configuré pour mesurer, selon au moins un axe de mesure $x_i$, $y_i$, $z_i$, un champ magnétique $B_i$ auquel il est soumis. Ce champ magnétique est une somme d'un champ magnétique utile $B_i^{15}$, généré par l'aimant 15, et d'un champ magnétique ambiant, noté $B^{env}$, dû à l'environnement magnétique dans lequel est disposé le dispositif, ainsi qu'une dérive de la réponse du magnétomètre, formant un signal d'offset noté $B_i^{offset}$. Le signal d'offset dépend de chaque magnétomètre, tandis que le champ magnétique ambiant est considéré comme identique pour tous les magnétomètres. Autrement dit, $B_i = B_i^{15} + B^{env} + B_i^{offset}$.

Etape 100 : mesure d'un champ de référence. Au cours de cette étape, chaque magnétomètre 10$i$ mesure un champ magnétique $\boldsymbol{B}_i(t_{ref})$ dit champ magnétique de référence. Cette mesure est réalisée à un instant de référence $t_{ref}$. A la différence de l'art antérieur, l'aimant 15 peut être placé dans une position de référence telle qu'il produit un champ magnétique significatif pour au moins un magnétomètre, et de préférence pour l'ensemble des magnétomètres. Par ailleurs, on note $\boldsymbol{m_{ref}}(t_{ref})$ le moment magnétique dit de référence de l'aimant audit instant de référence.

Etape 110 : affectation d'une position de référence. Au cours de cette étape, on affecte une position de référence, notée $\boldsymbol{r_{ref}}(t_{ref})$, correspondant aux coordonnées de l'aimant 15 dans le référentiel R. Lorsqu'on ne dispose d'aucun a priori quant à cette position de référence, elle peut être définie arbitrairement, par exemple à une position prédéterminée.

**Etape 120** : incrémentation du temps. Le temps étant discrétisé selon un pas d'échantillonnage temporel, l'étape 120 consiste à incrémenter le temps par rapport à l'instant de référence $t_{ref}$ considéré au cours des étapes 100 à 110.

Les étapes suivantes sont réalisées de manière itérative, à chaque itération de rang n étant associé un instant $t_n$, dit instant de mesure ou instant courant.

Etape 130 : mesure du champ magnétique $\boldsymbol{B}_i(t_n)$, à l'instant courant $t_n$, par chaque magnétomètre $10_i$.

Etape 140 : mesure différentielle: pour chaque magnétomètre $10_i$, calcul d'un champ magnétique différentiel $\Delta\mathbf{B}_i(t_n)$ représentant une différence entre le champ magnétique $\boldsymbol{B}_i(t_n)$ mesuré lors de l'étape 130 et le champ magnétique de référence $\boldsymbol{B}_i(t_{ref})$ mesuré lors de l'étape 100. Pour chaque magnétomètre, la différence est réalisé par une soustraction, axe par axe, des composantes du champ magnétique à l'instant courant et à l'instant de référence. On constitue alors un vecteur de mesures différentielles $\Delta\boldsymbol{B}(t_n)$, comprenant l'ensemble des champs magnétiques différentiels $\Delta\mathbf{B}_i(t_n)$ des magnétomètres considérés. Dans cet exemple, où l'on dispose de 32 magnétomètres tri-axes, le vecteur $\Delta\boldsymbol{B}(t_n)$ contient 96 termes, chaque terme représentant une mesure, selon un axe, du champ magnétique différentiel au niveau d'un magnétomètre $10_i$. L'avantage des mesures différentielles est de pouvoir s'affranchir du champ magnétique ambiant ainsi que du signal d'offset de chaque magnétomètre $10_i$. En effet :

$$\Delta \boldsymbol{B}_i(t_n) = \boldsymbol{B}_i(t_n) - \boldsymbol{B}_i(t_{ref})$$

$$= \boldsymbol{B}_i^{15}(t_n) + \boldsymbol{B}^{env}(t_n) + \boldsymbol{B}_i^{offset}(t_n) - \boldsymbol{B}_i^{15}(t_{ref}) - \boldsymbol{B}^{env}(t_{ref}) - \boldsymbol{B}_i^{offset}(t_{ref}).$$

Sous réserve d'un renouvellement régulier de l'instant de référence $t_{ref}$ et de la mesure du champ magnétique $\boldsymbol{B}_i(t_{ref})$ à cet instant, on peut considérer que $\boldsymbol{B}^{env}(t_n) \approx \boldsymbol{B}^{env}(t_{ref})$ et que $\boldsymbol{B}_i^{15}(t_n) \approx \boldsymbol{B}_i^{offset}(t_{ref}).$ Ainsi, la mesure différentielle $\Delta \mathbf{B}_i(t_n)$ est indépendante du champ magnétique ambiant ainsi que du signal d'offset de chaque détecteur. Le renouvellement de l'instant de référence sera décrit par la suite.

Etape 150 : estimation de la position de l'aimant à l'instant courant.

D'une façon générale, on détermine, lors de cette étape, un vecteur d'état $\boldsymbol{x}(t_n)$, comprenant une estimation de la position de l'aimant $\boldsymbol{r}(t_n)$ à l'instant courant $t_n$, cette estimation étant réalisée en fonction du vecteur d'état $\boldsymbol{x}(t_{n-1})$ estimé lors de l'itération précédente. Lors de la première itération, l'estimation est réalisée en fonction d'un vecteur d'état initialisé. L'estimation est réalisée en mettant en oeuvre un estimateur récursif de type filtre de Kalman étendu. Le vecteur d'état $\boldsymbol{x}(t_n)$ comporte :

-    une estimation de la position $\boldsymbol{r}(t_n)$ de l'aimant à l'instant courant $t_n$, ainsi qu'une estimation de son moment magnétique $\boldsymbol{m}(t_n)$, à partir de laquelle il est possible de déterminer l'orientation de l'aimant $\theta(t_n)$ ;
-    une estimation de la position de référence de l'aimant $\boldsymbol{r}_{ref}(t_n)$ à l'instant courant $t_n$, ainsi qu'une estimation du moment magnétique de référence $\boldsymbol{m}_{ref}(t_n)$ , à partir de laquelle il est possible de déterminer l'orientation de l'aimant à l'instant de référence $\theta_{ref}(t_n)$. Lors de la première itération, la position de référence $\boldsymbol{r}_{ref}(t_{ref})$ de l'aimant correspond à une position de l'aimant affectée à l'instant de référence : elle est soit connue, soit déterminée arbitrairement.

Dans cet exemple, le vecteur d'état comporte les estimations :

-    des coordonnées de l'aimant, à l'instant courant $t_n$ et à l'instant de référence $t_{ref}$, selon chaque axe X,Y,Z du référentiel $R$ lié au châssis ;
-    des composantes $m_x$, $m_y$, $m_z$ du moment magnétique de l'aimant selon les axes respectifs X,Y,Z du référentiel $R$ à chacun de ces instants.

Le vecteur d'état $\boldsymbol{x}(t_n)$ est donc, dans cet exemple, un vecteur de dimension (12,1).

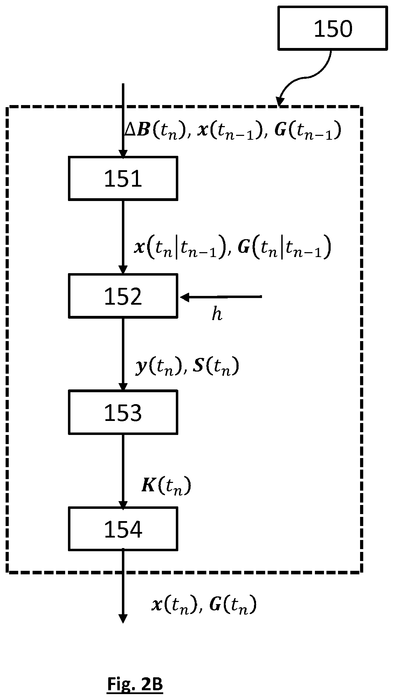

On décrit à présent, en lien avec la figure 2B, les sous-étapes de cette étape 150, comportant une sous-étape 151 d'estimation du vecteur d'état, une sous-étape 152 de calcul de l'innovation, une sous-étape 153 de calcul du gain et une sous-étape 154 de mise à jour du vecteur d'état sur la base des calculs des sous-étapes 151 à 153.

-    Sous-étape 151 : estimation. On estime le vecteur d'état $\boldsymbol{x}(t_n)$ connaissant le vecteur d'état $x(t_{n-1})$ issu de l'itération précédente, cette estimation étant notée $x(t_{n|n-1})$, d'après l'expression

$$\boldsymbol{x}(t_n|t_{n-1}) = f\big(\boldsymbol{x}(t_{n-1})\big)\ (1).$$

Dans cet exemple, $\boldsymbol{x}(tn|t_{n-1}) = \boldsymbol{x}(t_{n-1})$, la fonction de prédiction $f$ est la fonction identité. Selon une variante, la fonction de prédiction prend en compte une ou plusieurs positions précédentes, ainsi qu'une estimation de paramètres cinématiques relatifs au déplacement et/ou la rotation de l'aimant au cours des itérations précédentes : ces paramètres cinématiques peuvent être une vitesse, une accélération, une vitesse angulaire, une accélération angulaire. Lors de la première itération, on se base sur un vecteur d'état initial déterminé en fonction de la position $\boldsymbol{r}_{ref}(t_{ref})$ de l'aimant à l'instant de référence, et du moment magnétique $\boldsymbol{m}_{ref}$ à cet instant.

Lors de l'étape 151, on estime également une matrice de covariance de l'erreur $\boldsymbol{G}(t_n|t_{n-1})$ selon l'expression

$$\boldsymbol{G}(t_n|t_{n-1}) = \boldsymbol{F}(t_n)\boldsymbol{G}(t_{n-1})\boldsymbol{F}^T(t_n) + \boldsymbol{Q}(t_n),\ (2)$$

où :

- $F(t_n)$ est une matrice de prédiction, reliant l'état précédent $n$ - 1 à l'état courant $n$. Dans cet exemple, il s'agit de la matrice identité, de dimension (12, 12) ;
  - $T$ désigne l'opérateur de transposition ;
  - $Q(t_n)$ est une matrice de covariance de bruit du processus, de dimension (12, 12) ;
  - $G(t_{n-1})$ est la matrice de covariance de l'erreur. Elle résulte de l'itération précédente. Lors de la première itération ($n$ = 1), $G(t_{n-1})$ est initialisée selon une matrice diagonale.

- Sous-étape 152 : calcul du vecteur d'innovation et de la covariance du vecteur d'innovation. Le vecteur d'innovation $y(t_n)$ est déterminé selon l'expression :

$$y(t_n) = \Delta B(t_n) - h\big(x(t_n|t_{n-1})\big) \ (3),$$

où :

  - $\Delta B(t_n)$ est le vecteur de mesures différentielles établi lors de l'étape 140, de dimension (96,1) ;
  - $h$ est une fonction représentant le modèle direct, reliant les termes du vecteur d'état aux termes du vecteur de mesures différentielles $\Delta B(t_n)$. $h(x(t_n|t_{n-1}))$ est un vecteur de dimension (96,1). $h(x(t_n|t_{n-1}))$ représente une estimation du champ magnétique différentiel, pour chaque magnétomètre, à l'instant $t_n$. chaque terme du vecteur $h(x(t_n|t_{n-1}))$ représente une estimation, selon un axe, du champ magnétique différentiel au niveau d'un magnétomètre $10_i$. A l'instar du vecteur $\Delta B(t_n)$, le nombre de termes de ce vecteur est égal au nombre de magnétomètres $10_i$ considéré multiplié par le nombre d'axes de mesure de chaque magnétomètre.

Ainsi, le procédé comporte une comparaison entre des mesures, en l'occurrence le vecteur $\Delta B(t_n)$ , et une estimation de ces mesures, sous la forme du vecteur $h(x(t_n|t_{n-1}))$. Cette comparaison prend notamment la forme d'une soustraction.

La covariance du vecteur d'innovation $S(t_n)$ est obtenue selon l'expression :

$$S(t_n) = H(t_n)G(t_n|t_{n-1})H^T(t_n) + R(t_n) \ (4),$$

où :

  - $H(t_n)$ est une matrice reliant les mesures au vecteur d'état, chaque terme $H_{u,v}(t_n)$ de cette matrice étant tel que

$H_{u,v} = \dfrac{\partial \Delta B_u}{\partial x_v}$ où $u$ est l'indice des termes du vecteur $\Delta B(t_n)$ (dans cet exemple, $1 \leq u \leq 96$) et $v$ est l'indice des termes du vecteur d'état $x(t_n)$, (dans cet exemple, $1 \leq v \leq 12$). $H(t_n)$ est une matrice de dimension (96,12).
  - $R(t_n)$ est une matrice de covariance du bruit des mesures, de dimension (96,96).

Lorsque le vecteur d'état comporte une estimation des composantes du moment magnétique de l'aimant, cette étape peut comporter un conditionnement d'une estimation du module de ce champ magnétique par rapport à une valeur connue de ce module. Autrement dit, lesdites composantes du moment magnétique de l'aimant sont conditionnées, de telle sorte que le module du champ magnétique de l'aimant corresponde à une valeur, ou une plage de valeur, prédéterminée. Cela permet de réduire le nombre d'inconnues.

- Sous-étape 153 calcul du gain. Le gain du filtre de Kalman est une matrice $K(t_n)$, de dimension (12,96), telle que :

$$K(t_n) = G(t_n|t_{n-1})H^T(t_n)S^{-1}(t_n) \ (5)$$

- Sous étape 154 mise à jour du vecteur d'état. Le vecteur d'état $x(t_n)$ est mis à jour, à partir de la prédiction $x(t_n|t_{n-1})$, de l'innovation $y(t_n)$ et du gain $K(t_n)$ selon l'expression :

$$x(t_n) = x(t_n|t_{n-1}) + K(t_n)y(t_n) \ (6)$$

Cette étape comporte également la mise à jour de la matrice de covariance de l'erreur selon l'expression :

$$G(t_n) = (I - K(t_n)H(t_n))\, G(t_n|t_{n-1})\ (7),$$

où $I$ désigne la matrice identité.

Le vecteur d'état $x(t_n)$ ainsi déterminé comporte :

- une estimation de la position de l'aimant $r(t_n)$, et du moment magnétique $m(t_n)$ à l'instant courant ($t_n$), à partir duquel on peut déterminer une orientation $\theta$ de l'aimant, c'est-à-dire un ou plusieurs angles d'inclinaison, par exemple les angles $\theta_x$, $\theta_y$, $\theta_z$ précédemment évoqués.
- une estimation de la position de référence de l'aimant $r_{ref}(t_n)$, et du moment magnétique de référence $m_{ref}(t_n)$, ces estimations étant mises à jour à chaque instant courant $t_n$.

Au fur et à mesure des itérations, l'estimation de la position de référence de l'aimant $r_{ref}$ s'affine. Aussi, il n'est pas nécessaire que cette position soit estimée avec précision lors de la mesure du champ magnétique de référence $B_i(t_{ref})$.

Etape 160 : réitération. Au cours de l'étape 160, le temps est incrémenté d'une unité ($t_n = t_{n+1}$) et le processus itératif repart de l'étape 130, sur la base des estimations de $x(t_{n-1})$, et $G(t_{n-1})$ estimées lors de la sous-étape 154.

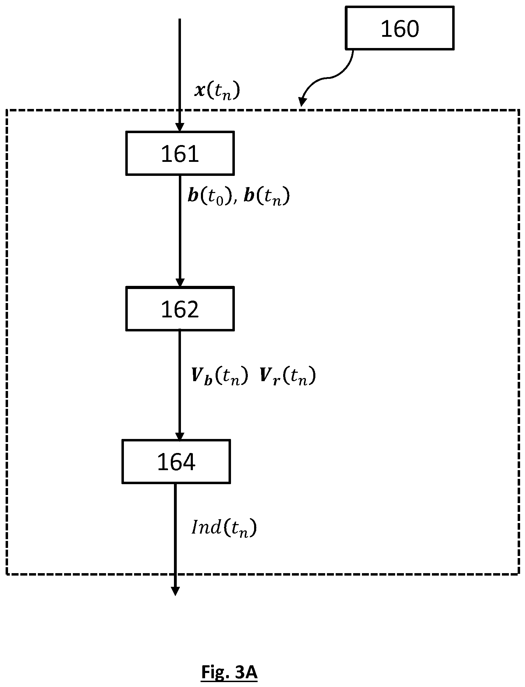

Préalablement à la nouvelle itération, l'étape 160 peut comprendre une étape de validation de l'estimation de la position de l'aimant $r(t_n)$. L'étape comprend alors 4 sous-étapes 161 à 164, décrites ci-dessous, en lien avec la figure 3A.

En effet, l'algorithme d'estimation du vecteur d'état $x(t_n)$ décrit ci-dessus peut converger vers deux configurations symétriques, dans lesquelles les estimations, à l'instant courant $t_n$, de la localisation de l'aimant $r(t_n)$, de son moment magnétique $m(t_n)$, de la position de référence $r_{ref}(t_n)$ et du moment magnétique de référence $m_{ref}(t_n)$ sont respectivement $r_1, m_1, r_2, m_2$ ou $r_2, -m_2, r_1, -m_1$. Cela est lié au fait que les mesures traitées par l'algorithme itératif sont des mesures différentielles, ainsi qu'à la propriété suivante :

$$B_i(r_1, m_1) - B_i(r_2, m_2) = B_i(r_2, -m_2) - B_i(r_1, -m_1)\ (8)$$

où $B_i(r_k, m_k)$ représente le champ magnétique mesuré par un magnétomètre $10_i$ produit par un aimant placé à une position $r_k$, et ayant un moment magnétique $m_k$.

Ainsi, le vecteur d'état $x(t_n)$ estimé à l'instant courant $t_n$ peut indifféremment indiquer :

- une localisation de l'aimant $r(t_n) = r_1$, son moment magnétique à cet instant étant $m_1$, la localisation et le moment magnétique à l'instant de référence étant respectivement $r_2$ et $m_2$ ;
- une localisation de l'aimant $r(t_n) = r_2$, son moment magnétique à cet instant étant $- m_2$, la localisation et le moment magnétique à l'instant de référence étant respectivement $r_1$ et $-m_1$.

Cela peut entraîner une confusion entre la position de l'aimant à l'instant courant et la position de référence. Afin de valider les estimations données par le vecteur d'état $x(t_n)$, l'étape 160 comporte le processus de validation suivant :

Sous-étape 161 : estimations barycentriques. Cette sous-étape comporte une sélection d'un groupe de magnétomètres $10i$ et, à partir du champ magnétique différentiel $\Delta B_i(t_n)$ mesuré à l'instant $t_n$ par chaque magnétomètre de ce groupe, elle comporte également l'estimation d'une position de l'aimant $b(t_n)$ dite barycentrique, dans le référentiel $R$, à l'instant de mesure, selon l'expression :

$$b(t_n) = \sum_i k_i(t_n)\, r_i\ (9)$$

où :

- $k_i(t_n)$ est un terme de pondération affecté au magnétomètre $10i$ à l'instant $t_n$. Par exemple, $k_i(t_n) = \|\Delta B'_i(t_n)\| = \|B_i(t_n) - B_i(t_{n-q})\|$, où $B_i(t_{n-q})$ est la valeur du champ magnétique $B_i$ mesuré par le magnétomètre $10_i$ à l'instant $t_{n-q}$. Cet instant $t_{n-q}$ est un instant voisin de l'instant $t_n$. Par voisin, on entend que l'intervalle temporel entre ces deux instants est de préférence inférieur à 5 secondes, voire inférieur à 2 s ou 1 s. L'indice $q$ est de préférence un entier compris entre 1 et 10. Dans cet exemple, $q = 5$. $\Delta \boldsymbol{B}_i'(t_n)$ est un champ magnétique différentiel dit instantané, car correspondant à une variation locale du champ magnétique entre deux instants $t_n$, $t_{n-q}$ voisins.

- $\boldsymbol{r}_i$ désigne les coordonnées d'un magnétomètre 10$i$ dans le référentiel du châssis $R$.

Cette sous-étape comporte également l'estimation d'une position barycentrique de la position de référence selon l'expression $\boldsymbol{b}(t_{ref}) = \sum_i k_i(t_{ref})\boldsymbol{r}_i$(10) où $k_i(t_{ref})$ est un terme de pondération affecté au magnétomètre 10$_i$ à l'instant

$$k_i\left(t_{ref}\right) = \left\| \Delta \boldsymbol{B_i}'(t_{ref}) \right\| = \left\| \boldsymbol{B_i}(t_{ref}) - \boldsymbol{B_i}(t_{ref \pm q'}) \right\|,$$

$t_{ref}$. Par exemple, où $\|\Delta \boldsymbol{B_i}'(t_{ref})\|$ est la norme d'un champ magnétique différentiel instantané, tel que défini dans le précédent paragraphe, audit instant de référence. $t_{ref \pm q'}$ désigne une ou quelques itérations temporelles avant ou après l'instant de référence $t_{ref}$, de telle sorte que l'instant $t_{ref} \pm q'$ corresponde sensiblement à l'instant de référence $t_{ref}$. L'indice $q'$ est de préférence un entier compris entre 1 et 10, et par exemple égal à 1.

Lorsque les magnétomètres sont coplanaires, ce qui est le cas de l'exemple décrit, chaque position barycentrique $\boldsymbol{b}(t_n)$ et $\boldsymbol{b}(t_{ref})$ correspond à une estimation de la position de l'aimant dans le plan des magnétomètres respectivement à l'instant de mesure et à l'instant de référence.

- Sous-étape 162 : détermination de vecteurs de déplacement. On détermine les coordonnées de deux vecteurs $\boldsymbol{V_b}(t_n)$ et $\boldsymbol{V_r}(t_n)$, respectivement représentatifs des déplacements entre les barycentres $\boldsymbol{b}(t_{ref})$ et $\boldsymbol{b}(t_n)$, ainsi qu'entre les positions $\boldsymbol{r}_{ref}(t_n)$ et $\boldsymbol{r}(t_n)$.

- Sous-étape 164 : validation du vecteur d'état : le vecteur d'état $\boldsymbol{x}(t_n)$ est validé en comparant les deux vecteurs $\boldsymbol{V_b}(t_n)$ et $\boldsymbol{V_r}(t_n)$ préalablement déterminés. Par exemple, la comparaison peut être réalisée au moyen d'un produit scalaire entre ces vecteurs. Ce produit scalaire peut être normalisé par un produit de la norme de chacun des vecteurs $\boldsymbol{V_b}(t_n)$ et $\boldsymbol{V_r}(t_n)$. On obtient alors un indicateur normalisé $ind(t_n)$ dont la valeur permet de valider ou non le vecteur d'état $\boldsymbol{x}(t_n)$ estimé au cours de l'itération.

$$ind(t_n) = \frac{\boldsymbol{V_b}(t_n) . \boldsymbol{V_r}(t_n)}{\|\boldsymbol{V_b}(t_n)\| \times \| \boldsymbol{V_r}(t_n)\|} \ (10)$$

où . représente l'opérateur produit scalaire et $\times$ représente une multiplication.

La normalisation par le produit des normes permet d'obtenir un indicateur $ind(t_n)$, associé à l'instant $t_n$, tel que $-1 \leq ind(t_n) \leq 1$. Cet indicateur représente le cosinus de l'angle formé par les vecteurs $\boldsymbol{V_b}(t_n)$ et $\boldsymbol{V_r}(t_n)$. Lorsque $ind(t_n) \geq 0.7$, le vecteur d'état est $\boldsymbol{x}(t_n)$ est validé. Lorsque $\overline{ind(t_n)} < 0.7$, le vecteur d'état n'est pas mis à jour et une nouvelle itération est mise en oeuvre. Lorsque $ind(t_n) < -0.7$, le vecteur d'état peut être invalidé et corrigé comme décrit ci-après, une telle valeur indiquant une probable inversion entre l'estimation de la position de référence $\boldsymbol{r}_{ref}(t_n)$ et la position de l'aimant $\boldsymbol{r}(t_n)$ à l'instant $t_n$. D'une façon générale, cette comparaison vise à déterminer un indicateur $ind(t_n)$ comparant les orientations respectives des deux vecteurs de déplacement $\boldsymbol{V_b}(t_n)$ et $\boldsymbol{V_r}(t_n)$, le vecteur d'état $\boldsymbol{x}(t_n)$ étant validé si ces orientations sont considérées comme étant suffisamment proches.

Le principe de l'étape de validation 160 est de comparer une estimation précise, mais incertaine, de la position de l'aimant, donnée par le vecteur d'état, à une estimation moins précise de cette position, mais certaine, donnée par le calcul barycentrique.

Lorsque le vecteur d'état est invalidé, il peut faire l'objet d'une correction en corrigeant la position de l'aimant et la position de référence, ainsi que les moments magnétiques à l'instant de mesure et à l'instant de référence. Cette correction peut être réalisée en effectuant simultanément les mises à jour suivantes :

$$\boldsymbol{r}_{ref}(t_n) \rightarrow \boldsymbol{r}(t_n) \ (12.1)$$

$$- \boldsymbol{m}_{ref}(t_n) \rightarrow \boldsymbol{m}(t_n) \ (12.2)$$

$$r(t_n) \rightarrow r_{ref}(t_n) \ (12.3)$$

$$-m(t_n) \rightarrow m_{ref}(t_n) \ (12.4)$$

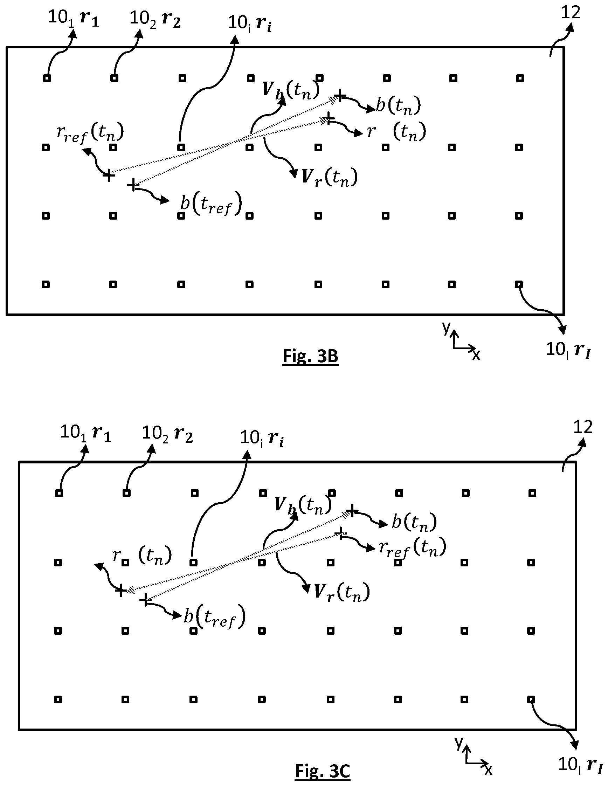

Les figures 3B et 3C représentent respectivement deux configurations, selon lesquelles le vecteur d'état $x(t_n)$ est validé et non validé. Sur chaque figure, on a représenté les magnétomètres $10_1, 10_2, \dots 10_i, \dots 10_l$, et leurs positions associées $r_1, r_2, \dots r_i, \dots r_l$. On a également représenté les positions barycentriques $b(t_n)$ et $b(t_{ref})$. Dans cet exemple, les magnétomètres sont coplanaires. Les positions barycentriques $b(t_n)$ et $b(t_{ref})$ sont donc dans le plan XY des magnétomètres. Sont également représentées les positions $r(t_n)$ et $r_{ref}(t_n)$, ces dernières pouvant avoir une coordonnée, selon l'axe Z, différente l'une de l'autre. La figure 3B correspond au cas où le vecteur d'état est correctement estimé : les vecteurs de déplacement $V_b(t_n)$ et $V_r(t_n)$ s'étendent selon des orientations proches l'une de l'autre et l'indicateur $ind(t_n)$ est positif, avec une valeur proche de 1. Dans ce cas, le vecteur d'état $x(t_n)$ est validé.

La figure 3C représente une configuration symétrique à celle de la figure 3B, selon laquelle l'algorithme de l'étape 150 estime un vecteur d'état $x(t_n)$, dans lequel les positions de référence et de l'aimant à l'instant courant sont inversées. Les vecteurs $V_b(t_n)$ et $V_r(t_n)$ ont des orientations quasiment opposées, et l'indicateur $ind(t_n)$ est négatif. Dans ce cas, le vecteur d'état $x(t_n)$ n'est pas validé. La projection de la position de l'aimant $r(t_n)$ n'est pas correctement estimée par la position barycentrique $b(t_n)$, l'estimation de cette dernière étant plus robuste, mais moins précise. Le vecteur d'état est donc erroné et doit être soit ne pas être pris en compte, soit corrigé.

D'autres procédés de validation peuvent être mis en oeuvre. Par exemple, un vecteur d'état est invalidé lorsque la position $r(t_n)$ est plus proche de la position barycentrique de référence $b(t_{ref})$ que de la position barycentrique à l'instant de mesure $b(t_n)$. Une autre option est d'établir un indicateur égal au minimum de :

- la norme du vecteur $r_{ref}(t_n)$-$b(t_{ref})$ additionnée de la norme du vecteur $r(t_n)$ - $b(t_n)$;
- la norme du vecteur $r_{ref}(t_n)$ - $b(t_n)$ additionnée de la norme du vecteur $r(t_n)$ - $b(t_{ref})$. Autrement dit, selon ce mode de réalisation, l'étape 140 comprend l'établissement d'un indicateur $ind(t_n)$ tel que :

$$ind(t_n) = \min\left[\left(\left\|r_{ref}(t_n) - b(t_{ref})\right\| + \left\|r(t_n) - b(t_n)\right\|\right); \left(\left\|r_{ref}(t_n) - b(t_n)\right\| + \left\|r(t_n) - b(t_{ref})\right\|\right)\right] \ (13)$$

Si $ind(t_n) = \|r_{ref}(t_n) - b(t_{ref})\| + \|r(t_n) - b(t_n)\|$, le vecteur d'état est validé ;

Si $ind(t_n) = \|r_{ref}(t_n) - b(t_n)\| + \|r(t_n) - b(t_{ref})\|$, le vecteur d'état n'est pas validé.

Quel que soit le mode de réalisation, au cours d'une itération $n$, ou au cours de chaque itération, l'étape 130 peut comporter une sous-étape de sélection de magnétomètres 10i selon l'intensité du champ magnétique $B_i(t_n)$ mesuré, par chacun d'entre eux, à l'instant $t_n$. Cela peut consister à sélectionner un groupe de magnétomètres mesurant un champ magnétique, dont l'intensité, déterminée à partir de la norme $\|B_i(t_n)\|$, se situe au-delà et/ou en deçà de seuils prédéterminés. Cela permet de s'affranchir de magnétomètres considérés comme saturés (intensité du champ magnétique trop élevée) et/ou dont la mesure n'est pas considérée comme significative (intensité du champ magnétique trop faible). Les seuils de sélection peuvent être préalablement établis. Lors des étapes 140 et 150 suivantes la sélection, les dimensions du vecteur différentiel $\Delta B(t_n)$, du vecteur innovation $y(t_n)$, et des matrices $H(t_n)$, $R(t_n)$, $K(t_n)$, $S(t_n)$ sont adaptées au nombre de magnétomètres ainsi sélectionnés. Le nombre de magnétomètres sélectionnés lors d'une itération n peut varier entre les différentes itérations.

Prise en compte d'un champ magnétique ambiant

Selon un mode de réalisation, lors de l'étape 150, le procédé comprend, à l'instant de mesure $t_n$ une prise en compte du champ magnétique ambiant, dû au champ magnétique terrestre ou à une autre source de champ magnétique produisant un champ homogène sur l'ensemble des magnétomètres. Cette prise en compte est réalisée en déterminant, au cours de l'étape 152, un vecteur représentant un champ magnétique différentiel moyen $\overline{\Delta B(t_n)}$. Pour obtenir ce vecteur, on calcule, pour l'ensemble des magnétomètres 10i :

- un vecteur $\overline{B}(t_n)$ représentant une moyenne, éventuellement pondérée, de chaque vecteur $B_i(t_n)$ mesuré à l'instant $t_n$ ;
- un vecteur $\overline{B}(t_{ref})$ représentant une moyenne, éventuellement pondérée, de chaque vecteur $B_i(t_{ref})$ mesuré à l'instant de référence $t_{ref}$ ;

Dans le cas où on effectue une moyenne pondérée, on peut utiliser des facteurs de pondération élevés (par exemple 1) pour les magnétomètres dont la distance par rapport à l'aimant est supérieure à une distance seuil, et un facteur de pondération nul sur les autres. En variante, chaque facteur de pondération est représentatif de l'incertitude de la mesure d'un capteur. Plus l'incertitude de mesure est élevée, plus le facteur de pondération est faible.

Le vecteur $\overline{\Delta\boldsymbol{B}(t_n)}$ représentant le champ magnétique différentiel moyen est obtenu par une soustraction du vecteur $\overline{B}(t_n)$ et du vecteur $\overline{B}(t_{ref})$ : $\overline{\Delta\mathbf{B}(t_n)} = \overline{B}(t_n) - \overline{B}(t_{ref})$.

Ce vecteur $\overline{\Delta\boldsymbol{B}(t_n)}$ a une dimension égale au nombre d'axes de mesure considérés sur les différents magnétomètres. Dans le cas de magnétomètres tri-axes, la dimension du vecteur représentant le champ différentiel moyen est (3,1).

On détermine alors un vecteur dit redimensionné $\overline{\overline{\Delta\boldsymbol{B}(t_n)}}$, de même dimension que le vecteur $\Delta\boldsymbol{B}(t_n)$ de mesures différentielles, établi lors de l'étape 140, c'est-à-dire le nombre de magnétomètres considérés multiplié par le nombre d'axes de mesure. Dans cet exemple, cette dimension est égale à 32 x 3 = 96. Le vecteur champ magnétique différentiel moyen redimensionné $\overline{\overline{\Delta\boldsymbol{B}(t_n)}}$ est obtenu en concaténant les termes du vecteur $\overline{\Delta\boldsymbol{B}(t_n)}$ autant de fois qu'il y a de magnétomètres considérés. Le vecteur $\overline{\overline{\Delta\boldsymbol{B}(t_n)}}$ est de dimension (96,1).

Par ailleurs, on détermine une moyenne du champ magnétique différentiel estimé $\overline{h(\boldsymbol{x}(t_n|t_{n-1}))}$, dont chaque terme est la moyenne des termes du vecteur $h(\boldsymbol{x}(t_n|t_{n-1}))$, déterminé lors de la sous-étape 152, correspondant au même axe de mesure. Dans le cas où on considère des magnétomètres tri-axes, on effectue une moyenne des termes, correspondant respectivement à chaque axe de mesure, du vecteur $h(\boldsymbol{x}(t_n|t_{n-1}))$. Comme précédemment décrit en relation avec la détermination du vecteur $\overline{\Delta\boldsymbol{B}(t_n)}$, cette moyenne peut être pondérée., auquel cas le vecteur $\overline{\Delta\boldsymbol{B}(t_n)}$ et $\overline{h(\mathrm{x}(t_n|t_{n-1}))}$ sont déterminés en utilisant les mêmes facteurs de pondération. On obtient le vecteur $\overline{h(\boldsymbol{x}(t_n|t_{n-1}))}$, représentant, pour chaque axe de mesure, le champ magnétique différentiel moyen estimé, la dimension de ce vecteur étant égale aux nombres d'axes de mesure considérés, en l'occurrence (3,1). On détermine alors un vecteur $\overline{h(\boldsymbol{x}(t_n|t_{n-1}))}$ redimensionné, représentant le champ magnétique différentiel moyen estimé. De même que le vecteur $\overline{\overline{\Delta\boldsymbol{B}(t_n)}}$, le vecteur $\overline{\overline{h(\boldsymbol{x}(t_n|t_{n-1}))}}$ est obtenu en concaténant les termes du vecteur $\overline{h(\boldsymbol{x}(t_n|t_{n-1}))}$ autant de fois qu'il y a de magnétomètres $10_i$ considérés.

Dans cet exemple, le vecteur $\overline{\overline{h(\boldsymbol{x}(t_n|t_{n-1}))}}$ est de dimension (96,1).

Le calcul de l'innovation est ensuite obtenu selon l'équation (3') :

$$\boldsymbol{y}(t_n) = \Delta\boldsymbol{B}(t_n) - \overline{\overline{\Delta\boldsymbol{B}(t_n)}} - \left( h\big(\boldsymbol{x}(t_n|t_{n-1})\big) - \overline{\overline{h\big(\boldsymbol{x}(t_n|t_{n-1})\big)}} \right) (3')$$

avec

$$\overline{\overline{\Delta\boldsymbol{B}(t_n)}} = \begin{matrix} \overline{\Delta\boldsymbol{B}(t_n)} \\ \vdots \\ \overline{\Delta\boldsymbol{B}(t_n)} \end{matrix} \quad \text{et} \quad \overline{\overline{h\big(\boldsymbol{x}(t_n|t_{n-1})\big)}} = \begin{matrix} \overline{h\big(\boldsymbol{x}(t_n|t_{n-1})\big)} \\ \vdots \\ \overline{h\big(\boldsymbol{x}(t_n|t_{n-1})\big)} \end{matrix}$$

*Renouvellement de la position de référence.*

Dans la description qui précède, la prise en compte d'une position de référence est réalisée au cours des étapes 100 et 110, avant l'estimation de la position de l'aimant aux différents instants de mesure. Mais au cours du procédé itératif, une nouvelle position de référence peut être prise en compte, sans qu'il soit nécessaire d'éloigner l'aimant des magnétomètres. C'est d'ailleurs un avantage notable de l'invention, puisque chaque position de référence est associée à une mesure de la position de l'aimant et à une estimation du moment magnétique à un instant de référence. Aussi, un changement de position de référence peut être entrepris à tout moment, sans que l'utilisateur n'ait à éloigner l'aimant des magnétomètres. Au contraire, il est parfois préférable que le champ magnétique de référence $B_i(t_{ref})$ soit significatif pour l'ensemble des magnétomètres du dispositif. Cela permet un renouvellement de la position de référence sans contrainte pour l'utilisateur, et plus fréquent. On limite alors les effets de dérive du champ magnétique ambiant, et la précision de la localisation de l'aimant est améliorée. Cela permet d'utiliser des magnétomètres peu onéreux, en tolérant une éventuelle dérive de mesure puisque cette dérive de mesure est compensée par un renouvellement plus fréquent de la position de référence.

Le renouvellement peut être effectué :

- en comparant l'instant courant ($t_n$) et l'instant de référence ($t_{ref}$), la position de référence étant renouvelée lorsque l'intervalle temporel entre ces deux instants dépasse un seuil prédéterminé. Il s'agit d'un renouvellement régulier ;
- et/ou en analysant les paramètres de l'algorithme mis en oeuvre lors de l'étape 150, notamment les valeurs de l'innovation $y(t_n)$ ;
- et/ou lorsque l'aimant bouge peu, c'est-à-dire que durant un certain intervalle temporel, la distance qu'il parcourt est inférieure à une distance seuil.

Le renouvellement est donc réalisé automatiquement, sans intervention de l'utilisateur. Cela accroît la convivialité et la fiabilité du dispositif.

Lors du renouvellement de la position de référence, les étapes 100 et 110 sont réalisées et une nouvelle position de référence $r_{ref}$, associée à un nouveau temps de référence $t_{ref}$, sont considérés lors des itérations suivantes. Lors d'un tel renouvellement, on peut par exemple disposer d'un a priori sur la nouvelle position de référence $r_{ref}(t_{ref})$ , cette dernière pouvant être déterminée en fonction de la dernière position de l'aimant estimée avant le renouvellement de la position de référence. Cela permet d'augmenter la précision de localisation dès les premiers instants de mesure postérieurs au nouvel instant de référence.

Etablissement d'une pluralité de positions de références.

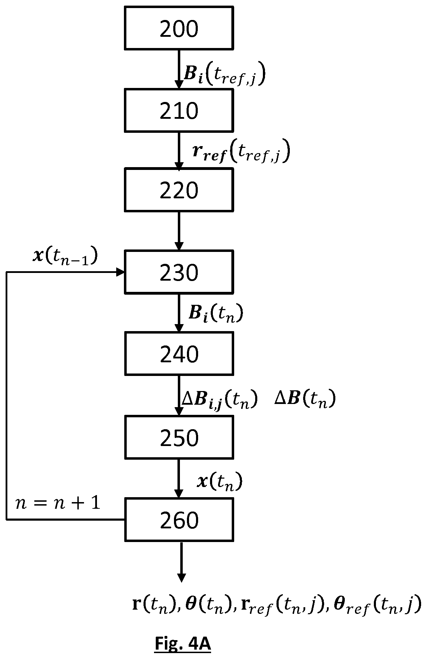

Selon un mode de réalisation, représenté sur la figure 4A, plusieurs positions de référence $r_{ref,j}$ sont prises en compte, chacune étant associée à un instant de référence $t_{ref,j}$ , à une position de référence $r_{ref}(t_{ref,j})$ à cet instant, et à un moment magnétique de référence $m_{ref,j}$. Le vecteur d'état comporte alors, outre l'estimation de la position de l'aimant $r(t_n)$ et de son moment $m(t_n)$ magnétique à l'instant courant, les estimations, à cet instant, d'une ou plusieurs positions de référence $r_{ref,j}(t_n)$ et du moment magnétique de référence $m_{ref,j}(t_n)$ associé. L'indice $j$ se rapporte à la position de référence considérée, avec $1 \leq j \leq J$, $J$ étant le nombre de positions de référence considérées. $J$ peut par exemple être égal à 10. Les étapes 200 et 210 sont respectivement analogues aux étapes 100 et 110 décrites en lien avec la figure 2A, si ce n'est que chacune de ces étapes est mise en oeuvre relativement à une position de référence $j$.

L'étape 230 est analogue à l'étape 130 précédemment décrite, chaque magnétomètre $10_i$ mesurant un champ magnétique $B_i(t_n)$ à l'instant de mesure ($t_n$).

Lors de l'étape 240, pour chaque magnétomètre $10_i$, on calcule un champ magnétique différentiel $\Delta B_{i,j}(t_n)$ chaque champ magnétique différentiel correspondant à une différence entre le champ magnétique $B_i(t_n)$ mesuré par le magnétomètre $10_i$ et le champ magnétique $B_i(t_{ref,j})$ mesuré par le champ magnétomètre $10_i$ à l'instant de référence $t_{ref,j}$.

L'étape 250 de détermination du vecteur d'état $x(t_n)$ peut alors être réalisée, de façon analogue à l'étape 150, en se basant sur la position de référence $r_{ref,j}(t_{n-1})$ la plus éloignée de la position de l'aimant déterminée lors de l'itération précédente.

Selon un mode de réalisation, l'étape 250 peut être mise en oeuvre en considérant successivement chacune des positions de référence, de façon à estimer un vecteur d'état dit intermédiaire $x(t_{n,j})$ associé à chaque position de référence $j$. Ce vecteur d'état intermédiaire comprend alors outre l'estimation de la position $r(t_{n,j})$ et du moment magnétique $m(t_{n,j})$ de l'aimant à l'instant courant ($t_n$), une estimation de la $j^{ème}$ position de référence $r_{ref}(t_{n,j})$ et du moment magnétique $m_{ref}(t_{n,j})$ associé à la $j^{ème}$ position de référence. On détermine alors successivement autant de vecteurs d'état intermédiaires $x(t_{n,j})$ qu'il y a de positions de références considérées. Chaque vecteur d'état intermédiaire comporte une estimation de la position de l'aimant $r(t_{n,j})$, à l'instant de mesure ($t_n$), dite intermédiaire, établie relativement à une position de référence d'indice $j$.

On peut alors établir un vecteur d'état $x(t_n)$ en effectuant une moyenne de chaque vecteur d'état intermédiaire $x(t_{n,j})$. La position de l'aimant $r(t_n)$ est alors estimée en effectuant une moyenne des positions intermédiaires $r(t_{n,j})$. Eventuellement, cette moyenne peut être pondérée par un facteur de pondération associé à chaque position intermédiaire. Le facteur de pondération peut par exemple être d'autant plus élevé que l'estimation de la position de référence $r_{ref}(t_{n,j})$ est éloignée de la position intermédiaire $r(t_{n,j})$ qui lui est associée. Il peut également être pondéré par l'inverse de la norme du vecteur innovation $y(t_{n,j})$.

La position de l'aimant peut également être estimée en ne considérant que le vecteur d'état intermédiaire $x(t_{n,j})$ , ou les vecteurs d'état intermédiaires, dont l'indice $j$ correspond à la position (ou aux positions) intermédiaires $r(t_{n,j})$ les plus éloignées des positions de référence $r_{ref}(t_{n,j})$ auxquelles elles sont associées. On peut alors définir une distance seuil, de telle sorte qu'un vecteur d'état intermédaire $x(t_{n,j})$ n'est pris en compte que si la position de référence $r_{ref}(t_{n,j})$ à laquelle il est associé est située à une distance supérieure de la distance seuil de ladite position intermédiaire $r(t_{n,j})$. Une telle distance seuil peut être de quelques cm, par exemple 1 ou 2 cm. Le vecteur d'état $x(t_n)$ est alors déterminé en fonction du vecteur d'état intermédiaire ainsi sélectionné, ou d'une moyenne des vecteurs d'états intermédiaires sélectionnés. La prise en compte d'une position de référence $r_{ref}(t_{n,j})$ peut également être conditionnée par la valeur d'un indicateur de validité $V_j(t_n)$ associé à cette position de référence. Cet indicateur de validité est décrit ci-après.

Selon un mode de réalisation, lorsque plusieurs positions de référence sont prises en comptes, la position de l'aimant n'est estimée qu'en ne considérant que certaines positions de référence, par exemple les positions de référence ayant déjà fait l'objet d'un nombre minimal $n_{min}$ d'itérations. Autrement dit, lorsqu'une nouvelle position de référence $j$ - *new* est sélectionnée à un instant de référence $t_{ref,j-new}$, elle fait l'objet d'un nombre minimal d'itérations $n_{min}$, durant lesquelles on estime la position de l'aimant $r_{ref}(t_{n,j-new})$ à l'instant de référence. Tant que ce nombre minimal d'itérations n'est pas atteint, l'estimation de la position $r(t_n)$ de l'aimant n'est pas effectuée en considérant cette nouvelle position de référence. Ce nombre minimal d'itérations permet d'affiner l'estimation de la position de l'aimant $r_{ref}(t_{n,j-new})$ à l'instant référence pour la référence nouvellement sélectionnée. Cette dernière est prise en compte pour estimer la position de l'aimant $r(t_{n,j-new})$ lorsque la position de référence $r(t_{n,j-new})$ est estimée avec un suffisamment de précision. Le nombre minimal d'itérations peut être prédéterminé, où dépendre de la variation entre deux estimations successives $r_{ref}(t_{n,j-new}), r_{ref}(t_{n+1,j-new})$ de la position de l'aimant à l'instant de référence $t_{ref,j-new}$, cette dernière étant considérée comme fiable lorsque l'écart relatif entre deux estimations successives est suffisamment faible. Cela revient à considérer un « temps de chauffe », au cours duquel on affine l'estimation d'une position de référence nouvellement prise en compte, avant de l'utiliser dans l'estimation de la position de l'aimant.

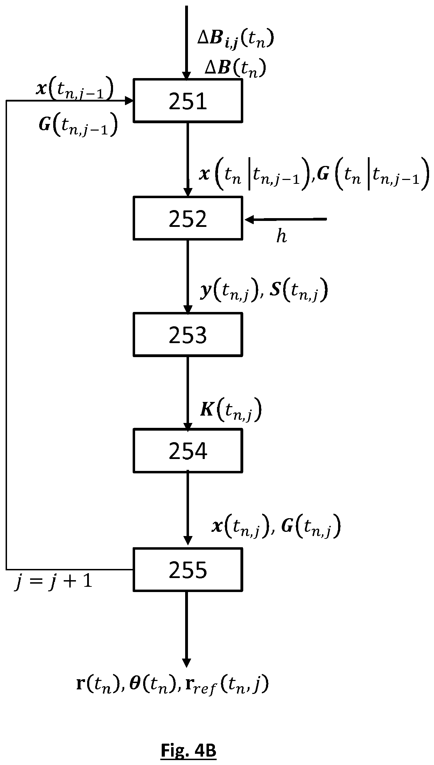

Selon une variante, représentée sur la figure 4B, l'étape 250 est mise en oeuvre de façon itérative, en considérant successivement, à chaque itération, chaque position de référence.

Aussi, lors d'une première itération ($j$ = 1), on détermine un vecteur d'état $x(t_{n,j=1})$, comportant une estimation intermédiaire de la position $r(t_{n,j=1})$ et du moment magnétique $m(t_{n,j=1})$ ainsi qu'une estimation de la 1<sup>re</sup> position de référence $r_{ref}(t_{n,j=1})$ et du moment magnétique $m(t_{n,j})$ de l'aimant au 1<sup>er</sup> instant de référence $t_{0,j=1}$. Le vecteur d'état intermédiaire $x(t_{n,j})$ ainsi que la matrice de covariance de l'erreur $G(t_{n,j})$, issus d'une itération $j$, sont alors mis en oeuvre dans l'étape 251 d'estimation du vecteur d'état de l'itération suivante ($j = j + 1$), selon les expressions :

$$x\big(t_{n,j}\big|t_{n,j-1}\big) = x\big(t_{n,j-1}\big)\ (1')$$

et

$$G\big(t_n\big|t_{n,j-1}\big) = F\big(t_n\big)G\big(t_{n,j-1}\big)F^T(t_n) + Q(t_n)\ (2').$$

L'algorithme se poursuit tel que précédemment décrit, de façon à déterminer :

- un vecteur d'innovation $y(t_{n,j})$, une matrice de covariance de l'innovation $S(t_{n,j})$ (étape 252);
- une matrice de gain $K(t_{n,j})$ (étape 253) ;
- l'estimation d'un vecteur d'état intermédiaire $x(t_{n,j})$ et de la matrice de covariance $G(t_{n,j})$ associée (étape 254) ces derniers étant utilisés lors de l'itération suivante (étape 255 puis étape 251).

Lors de la $J$<sup>ième</sup> itération, l'algorithme génère un vecteur d'état $x(t_n)$, correspondant au vecteur d'état intermédiaire $x(t_{n,j=J})$ de l'itération $J$. Ce vecteur fait, de préférence, l'objet d'une validation (étape 260), de façon similaire à l'étape 160 précédemment décrite, puis le processus est réitéré selon un temps de mesure $t_{n+1}$. On dispose alors d'une estimation de la position de l'aimant $r(t_n)$, ainsi que de son moment magnétique $m(t_n)$, à partir duquel l'orientation $\theta(t_n)$ peut être calculée . On dispose également d'une réactualisation de chaque position de référence $r_{ref}(t_{n,j})$.

Selon une variante, le vecteur d'état $x(t_n)$ comprend l'ensemble des positions de référence, qui servent de base à la mesure d'une pluralité de champs magnétiques différentiels. Ces positions de référence sont affinées au fur et à mesure des itérations.

Selon une variante, plusieurs aimants sont déplacés, et le vecteur d'état comprend une estimation d'une position de chacun d'entre eux, ainsi qu'au moins une estimation de la position de référence. Le vecteur d'état peut également comporter une estimation d'une ou plusieurs composantes du moment magnétique de chaque aimant.

Lorsque plusieurs positions de référence sont prises en compte dans l'algorithme, une, ou plusieurs, de ces positions de référence peut-être l'infini, ou un moment magnétique nul. Cela correspond au cas où la position de référence est située en dehors de la plage de distance couverte par les magnétomètres. Le champ magnétique de référence $B_i(t_{ref})$ produit sur chaque magnétomètre $10_i$ du réseau est alors négligeable.

Dans chacun des modes de réalisation préalablement décrits, à chaque position de référence peut être affecté un indicateur de validité $V_j(t_n)$, représentant la validité d'une $j$<sup>ème</sup> position de référence à l'instant courant $t_n$. Cet indicateur de validité peut notamment être déterminé en fonction :

- d'une comparaison entre l'instant courant ($t_n$) et l'instant de référence ($t_{ref,j}$), associé à la position de référence d'indice $j$, la position de référence étant renouvelée lorsque l'intervalle temporel entre ces deux instants dépasse un seuil prédéterminé, ce qui permet une mise à jour régulière des positions de référence ;

- et/ou d'une analyse des paramètres de l'algorithme mis en oeuvre lors de l'étape 150, notamment les valeurs de l'innovation $y(t_{n,j})$ ;
- et/ou de l'obtention d'une répartition des positions de références $r_{ref}(t_n,j)$ distribuées spatialement. Ainsi, une position de référence est remplacée si une nouvelle position de référence se trouve dans son voisinage, c'est-à-dire à une distance inférieure à une distance préétablie. Cela permet d'optimiser la répartition spatiale des positions de référence.

Lorsque l'indicateur de validité indique qu'une position de référence n'est plus valide, cette dernière est remplacée selon les étapes 200 et 210 représentées sur la figure 4A ou selon les étapes 100 à 110 décrites en lien avec la figure 2A.

Fusion de positions de références.

Selon une variante, pouvant s'appliquer aux modes de réalisation basés sur l'utilisation de plusieurs références, plusieurs positions de références sont utilisées et on détermine une nouvelle position de référence basée sur une fusion desdites positions de références. Par exemple, on dispose d'une j$^{ième}$ position de référence et d'une j+1 $^{ième}$ position de référence.

A un instant courant l'instant courant ($t_n$), on estime, pour chaque magnétomètre 10i, les champs magnétiques ambiants $\widehat{B_i^{amb}}\left(t_{ref,j}\right)$ et $\widehat{B_i^{amb}}\left(t_{ref,j+1}\right)$ respectivement aux instants de référence ($t_{ref,j}$) et ($t_{ref,j+1}$). Par champ magnétique ambiant, on entend un champ magnétique dû à l'environnement d'un capteur ainsi qu'à la dérive du capteur :

$$B_i^{amb} = B^{env} + B_i^{offset}, B^{env} \text{ et } B_i^{offset} \text{ ayant été préalablement définis.}$$

- $\widehat{B_i^{amb}}\left(t_{ref,j}\right) = B_i\left(t_{ref}\right) - \widehat{B}_i\left(t_{ref,j} ; t_n\right),\ \ \widehat{B}_i\left(r_{ref}\left(t_{n,j}\right)\right)$ correspondant à une estimation du champ magnétique produit par l'aimant placé selon la j$^{ième}$ position de référence $r_{ref}(tn,j)$ telle qu'estimée à l'instant $t_n$ ;

- $\widehat{B_i^{amb}}\left(t_{ref,j+1}\right) = B_i\left(t_{ref}\right) - \widehat{B}_i\left(r_{ref}\left(t_{n,j+1}\right)\right),\ \ \widehat{B}_i\left(r_{ref}\left(t_{n,j+1}\right)\right)$ correspondant à une estimation du champ magnétique produit par l'aimant placé selon la j+1$^{ieme}$ position de référence $r_{ref}(t_{n,j+1})$ telle qu'estimée à l'instant $t_n$.

On peut définir une nouvelle référence j', basée sur les estimations $\widehat{B_i^{amb}}\left(t_{ref,j}\right)$ et $\widehat{B_i^{amb}}\left(t_{ref,j+1}\right)$ par exemple sous la forme d'une combinaison linéaire, telle que $\widehat{B_i^{amb}}\left(t_{ref,j'}\right) = \dfrac{\widehat{B_i^{amb}}\left(t_{ref,j}\right) + \widehat{B_i^{amb}}\left(t_{ref,j+1}\right)}{2}$ . Cette référence j', dite fusionnée correspond à une combinaison linéaire de champs magnétiques ambiants, en l'absence d'aimant. Ainsi, la position de référence $r(t_{ref,j'})$ est affectée à un moment de référence $m_{ref}$ nul et/ou à une position $r_{ref}$ à l'infini.

Bien que décrite en lien avec un réseau de magnétomètres coplanaires, l'invention pourra être mise en oeuvre en utilisant des magnétomètres agencés selon un réseau quelconque, décrivant par exemple une surface curviligne. De préférence, quel que soit le mode de réalisation, les magnétomètres sont reliés entre eux selon une liaison rigide, par exemple par l'intermédiaire du châssis 12.

Par ailleurs, le procédé décrit dans cette description est basé sur l'utilisation d'un filtre de Kalman étendu. L'invention couvre d'autres modes de réalisation mettant en oeuvre des estimateurs permettant l'inversion d'un modèle direct, et en particulier les estimateurs récursifs à la portée de l'homme du métier.

## Revendications

1. Procédé d'estimation d'une position ($r(t_n)$) d'un aimant (15), ledit aimant étant déplacé relativement à un réseau de magnétomètres, comprenant une pluralité de magnétomètres (10$_j$), chaque magnétomètre étant apte à mesurer un champ magnétique ($B_i$) généré par ledit aimant, selon au moins un axe de mesure ($x_i, y_i, z_i$), le procédé comportant les étapes suivantes :

a) mesure, par chaque magnétomètre, d'un champ magnétique de référence ($B_i(t_{ref})$, $B_i(t_{ref,j})$), à un instant de référence ($t_{ref}$, $t_{ref,j}$) ;

b) affectation d'une position de référence ($r_{ref}(t_{ref})$, $r_{ref}(t_{ref,j})$) de l'aimant audit instant de référence, la position de référence étant affectée à une position arbitraire ou à une estimation de la position de l'aimant à l'instant de référence ;

c) mesure d'un champ magnétique ($B_i(t_n)$) généré par ledit aimant, par chaque magnétomètre ($10_i$), à un instant de mesure ($t_n$), postérieur à l'instant de référence ;

d) calcul d'un champ magnétique différentiel ($\Delta B_i(t_n)$, $\Delta B_{i,j}(t_n)$), représentant une différence, pour chaque magnétomètre ($10_i$), entre le champ magnétique ($B_i(t_n)$) mesuré à l'étape c) et le champ magnétique de référence ($B_i(t_{ref})$, $B_{i,j}(t_{ref,j})$), mesuré à l'étape a) ;

e) à partir de chaque champ magnétique différentiel ($\Delta B_i(t_n)$, $\Delta B_{i,j}(t_n)$), et d'une estimation de ladite position de référence ($r_{ref}(t_{ref})$, $r_{ref}(t_{ref,j})$, $r_{ref}(t_{n-1})$, $r_{ref}(t_{n-1,j})$), estimation d'une position ($r(t_n)$) de l'aimant à l'instant de mesure ($t_n$), l'estimation étant réalisée par un estimateur récursif, la position de référence de l'aimant étant, lors d'une première itération, la position de l'aimant affectée à l'instant de référence ;

f) réitération des étapes c) à e), sur la base de l'estimation issue de l'étape e), en incrémentant l'instant de mesure;

le procédé étant tel que, lors de l'étape e), ladite position ($r(t_n)$) de l'aimant est estimée à partir :

- d'une estimation de la position de l'aimant à un instant ($t_{n-1}$, $t_{ref}$) précédent l'instant de mesure ($t_n$) ;
- d'une estimation de la position de référence, cette estimation étant réalisée à un instant ($t_{n-1}$, $t_{ref}$) précédent l'instant de mesure ($t_n$) ;

l'étape e) comprenant également une mise à jour, à l'instant de mesure ($t_n$), de l'estimation de la position de référence ($r_{ref}(t_n)$, $r_{ref}(t_{n,j})$).

**2.** Procédé selon la revendication 1, dans lequel, l'étape e) comporte une détermination d'un vecteur d'état ($x(t_n)$), relatif à l'instant de mesure ($t_n$), en fonction du vecteur d'état à un instant précédent l'instant de mesure, l'instant précédent étant un instant de référence ($t_{ref}$, $t_{ref,j}$) ou un instant de mesure ($t_{n-1}$) correspondant à une itération précédente, le vecteur d'état comportant :

- une estimation de la position de l'aimant à l'instant de mesure ;
- une estimation, à l'instant de mesure, d'au moins une position de référence de l'aimant;

le vecteur d'état étant actualisé à chaque itération.

**3.** Procédé selon la revendication 1 ou la revendication 2, comprenant, suite à l'étape e), une étape e') de validation des estimations respectives de la position de l'aimant à l'instant de mesure ($r(t_n)$, $r(t_{n,j})$) et de la position de référence ($r_{ref}(t_n)$, $r_{ref}(t_{n,j})$), cette étape comportant les sous-étapes suivantes :

i) détermination d'un déplacement ($V_b(t_n)$) de l'aimant entre l'instant de mesure ($t_n$) et l'instant de référence ($t_{ref}$, $t_{ref,j}$), en pondérant à chacun de ces instants, une position de chaque magnétomètre ($r_i$) par un facteur de pondération ($k_i(t_n)$, $k_i(t_{ref})$) dépendant du module du champ magnétique ($B_i(t_n)$, $B_i(t_{ref})$) mesuré par ledit magnétomètre ($10_i$) audit instant ;

ii) comparaison du déplacement déterminé lors de la sous-étape i) avec un déplacement ($V_r(t_n)$) calculé selon les estimations, à l'instant de mesure ($t_n$), de la position de l'aimant ($r(t_n)$) et de la position de référence ($r_{ref}(t_n)$, $r_{ref}(t_{n,j})$).

**4.** Procédé selon la revendication 3, dans lequel, la sous-étape i) comprend :

- la détermination, pour chaque magnétomètre, d'un champ magnétique différentiel dit instantané ($\Delta B_i'(t_n)$, $\Delta B_i'(t_{ref})$), représentant une variation entre le champ magnétique ($B_i(t_n)$, $B_i(t_{ref})$) mesuré à un premier instant et le champ magnétique ($B_i(t_{n-q})$, $B_i(t_{ref\pm q'})$) mesuré à un deuxième instant, ledit deuxième instant étant voisin dudit premier instant, ladite détermination étant réalisée en considérant successivement un premier instant correspondant à l'instant de mesure ($t_n$) et à l'instant de référence ($t_{ref}$), de façon à obtenir un champ magnétique différentiel instantané ($\Delta B_i'(t_n)$, $\Delta Bi'(t_{ref})$) à chacun de ces instants ;

- ladite détermination de chaque facteur de pondération ($k_i(t_n)$, $k_i(t_{ref})$) à l'instant de mesure et à l'instant de référence étant effectuée respectivement à partir du module du champ magnétique différentiel instantané ($\Delta Bi'(t_n)$, $\Delta B_i'(t_{ref})$), respectivement à l'instant de mesure et à l'instant de référence.

**5.** Procédé selon l'une quelconque des revendications précédentes, dans lequel :

- les étapes a) et b) sont répétées, de telle sorte qu'on dispose d'une pluralité de positions de référence ($j$), à chaque position de référence étant associés :

un instant de référence ($t_{ref,j}$) ;
une affectation de la position de l'aimant audit instant de référence ($r_{ref}(t_{ref,j})$) ;
une mesure du champ magnétique ($B_i(t_{ref,j})$), par chaque magnétomètre ($10_i$),
audit instant de référence ;

- l'étape d) comporte le calcul d'au moins un champ magnétique différentiel ($\Delta B_{i,j}(t_n)$), à partir d'au moins un champ magnétique de référence ($B_i(t_{ref,j})$).

**6.** Procédé selon la revendication 5, dans lequel à chaque position de référence ($j$) est associé un indicateur de validité ($V_j(t_n)$), conditionnant la prise en compte de ladite position de référence, à chaque instant de mesure ($t_n$), lors des étapes d) et e).

**7.** Procédé selon l'une quelconque des revendications 5 ou 6, dans lequel les étapes a) et b) sont répétées lorsque le nombre de positions de référence est inférieur à un nombre ($J$) prédéterminé de positions de référence.

**8.** Procédé selon l'une quelconque des revendications 5 à 7, dans lequel l'étape d) comprend le calcul d'une pluralité de champs magnétiques différentiels ($\Delta B_{i,j}(t_n)$), représentant chacun une différence, pour chaque magnétomètre ($10_i$), entre le champ magnétique ($B_i(t_n)$) mesuré à l'étape c) et chaque champ magnétique de référence ($B_i(t_{ref,j})$).

**9.** Procédé selon la revendication 8, dans lequel :

- l'étape e) comprend une pluralité d'estimations, dites intermédiaires, de la position ($r(t_{n,j})$) dudit aimant audit instant de mesure ($t_n$), chaque estimation intermédiaire étant basée sur une position de référence ($j$) différente l'une de l'autre, la position de l'aimant ($r(t_n)$) audit instant de mesure étant déterminée en fonction de ces estimations intermédiaires ($r(t_{n,j})$);
- l'étape e) comprend également une mise à jour de l'estimation, à l'instant de mesure ($t_n$), de chaque position de référence ($r_{ref}(t_{n,j})$).

**10.** Procédé selon la revendication 9, dans lequel lors de l'étape e), la position de l'aimant $r(t_n)$ à l'instant de mesure ($t_n$) est estimée :

- à partir d'une moyenne desdites estimations intermédiaires ($r(t_{n,j})$) ;
- et/ou en considérant la position de référence ($j$) la plus éloignée, ou une position de référence située au-delà d'une distance prédéterminée, de la pluralité d'estimations intermédiaires($r(t_{n,j})$) ;
- ou, à chaque position de référence ($j$) étant associés un indicateur de validité ($V_j(t_n)$), sur la base d'une position de référence sélectionnée en fonction de l'indicateur de validité ($V_j(t_n)$) qui lui est associé ;
- ou en considérant successivement chaque position de référence.

**11.** Procédé selon l'une quelconque des revendications précédentes, dans lequel l'étape e) comporte, outre une estimation de la position $r(t_n)$ de l'aimant à chaque instant de mesure, une estimation d'une orientation $\theta(t_n)$ de l'aimant à cet instant et/ou une estimation de composantes d'un moment magnétique de l'aimant à l'instant de mesure ($t_n$).

**12.** Procédé selon l'une quelconque des revendications précédentes, dans lequel :

- l'étape d) comprend une détermination, à l'instant de mesure ($t_n$), d'un champ magnétique différentiel moyen $\overline{(\Delta B(t_n))}$, représentant une différence entre une moyenne des champs magnétiques mesurés par chaque magnétomètre ($10_i$) respectivement à l'instant de mesure ($t_n$) et à l'instant de référence ($t_{ref}$) ;
- l'étape e) comprend une prise en compte dudit champ magnétique différentiel moyen $\overline{(\Delta B(t_n))}$, dont les termes sont soustraits au champ magnétique différentiel ($\Delta B_i(t_n), \Delta B_{i,j}(t_n)$).

**13.** Procédé selon la revendication 12, dans lequel l'étape e) comprend

- une estimation du champ magnétique différentiel ($h(\mathbf{x}(t_n|t_{n-1}))$) mesuré, à l'instant de mesure ($t_n$), par chaque magnétomètre ($10_i$), ainsi qu'une détermination d'une moyenne ($\overline{h(\mathbf{x}(t_n|t_{n-1}))}$) desdites estimations ;

- une prise en compte de ladite moyenne ($\overline{h(\boldsymbol{x}(t_n|t_{n-1}))}$) des estimations de chaque champ magnétique différentiel mesuré de chaque magnétomètre ($10_i$), dont les termes sont soustraits à ladite estimation du champ magnétique différentiel ($h(\mathbf{x}(t_n|t_{n-1}))$) mesuré, à l'instant de mesure ($t_n$), par chaque magnétomètre ($10_i$).

14. Procédé selon l'une quelconque des revendications précédentes, dans lequel l'étape e) comporte la détermination d'un vecteur d'état ($\boldsymbol{x}_n$), relatif à l'instant de mesure ($t_n$), ce vecteur d'état étant déterminé en fonction dudit vecteur d'état à un instant précédent l'instant de mesure, l'instant précédent la mesure étant l'instant de référence ($t_{n-1}$) ou un instant correspondant à une itération précédente ($t_{ref}$), le vecteur d'état comportant la position de l'aimant à l'instant de mesure.

15. Procédé selon la revendication 14, dans lequel l'étape e) comporte :

- une estimation du vecteur d'état à l'instant de mesure, sur la base d'un vecteur d'état relatif à l'instant précédent la mesure ;
- une mise à jour du vecteur d'état à l'instant de mesure, sur la base du champ magnétique différentiel ($\Delta\boldsymbol{B_i}(t_n),\Delta\boldsymbol{B_{i,j}}(t_n)$) déterminé lors de l'étape d).

16. Dispositif (1) de localisation d'un aimant mobile (15), l'aimant étant apte à être déplacé relativement à un réseau de magnétomètres ($10_i$), chaque magnétomètre étant apte à fournir, à différents instants de mesure ($t_n$), une mesure d'un champ magnétique ($\boldsymbol{B_i}(t_n)$), ($\boldsymbol{B_i}(t_{ref})$) produit par ledit aimant selon au moins un axe de mesure ($x_i,y_i,z_i$), le dispositif comportant un processeur configuré pour recevoir, à chaque instant de mesure, les mesures fournies par chaque magnétomètre, et pour mettre en oeuvre le procédé objet des revendications 1 à 15, de façon à estimer une position de l'aimant $\boldsymbol{r}(t_n)$ à chaque instant de mesure.

**Patentansprüche**

1. Verfahren zum Schätzen einer Position ($r(t_n)$) eines Magneten (15), wobei der Magnet relativ zu einer Anordnung von Magnetometern bewegt wird, umfassend eine Vielzahl von Magnetometern ($10_i$), wobei jedes Magnetometer in der Lage ist, ein von dem Magneten erzeugtes Magnetfeld ($B_i$) entlang mindestens einer Messachse ($x_i$, $y_i$, $z_i$), zu messen, wobei das Verfahren die folgenden Schritte umfasst:

a. Messung eines Referenzmagnetfelds ($\boldsymbol{B_i}(t_{ref})$, $\boldsymbol{B_i}(t_{ref,j})$) mit jedem Magnetometer zu einem Referenzzeitpunkt ($t_{ref}$, $t_{ref,j}$);

b. Zuordnung einer Referenzposition ($\boldsymbol{r_{ref}}(t_{ref})$, ($\boldsymbol{r_{ref}}(t_{ref,j})$) des Magneten zum Referenzzeitpunkt, wobei die Referenzposition einer beliebigen Position oder einer Schätzung der Position des Magneten zum Referenzzeitpunkt zugeordnet ist;

c. Messung eines Magnetfelds ($\boldsymbol{Bi}(t_n)$), das durch den Magneten erzeugt wird, durch jedes Magnetometer ($10_i$) zu einem Messzeitpunkt ($t_n$), der auf den Referenzzeitpunkt folgt;

d. Berechnen eines differentiellen Magnetfelds ($\varDelta\boldsymbol{B_i}(t_n)$, $\varDelta\boldsymbol{B_{i,j}}(t_n)$), das für jedes Magnetometer ($10_i$) eine Differenz zwischen dem in Schritt c) gemessenen Magnetfeld ($\boldsymbol{B_i}(t_n)$) und dem in Schritt a) gemessenen Referenzmagnetfeld ($\boldsymbol{B_i}(t_{ref})$, $\boldsymbol{B_{i,j}}(t_{ref,j})$) darstellt;

e. aus jedem differentiellen Magnetfeld ($\varDelta\boldsymbol{B_i}(t_n)$, $\varDelta\boldsymbol{B_{i,j}}(t_n)$) und einer Schätzung der Referenzposition ($\boldsymbol{r_{ref}}(t_{ref})$, $\boldsymbol{r_{ref}}(t_{ref,j})$, $\boldsymbol{r_{ref}}(t_{n-1})$, $\boldsymbol{r_{ref}}(t_{n-1,j})$)), Schätzung einer Position ($r(t_n)$) des Magneten zum Messzeitpunkt ($t_n$), wobei die Schätzung durch einen rekursiven Schätzer durchgeführt wird, wobei die Referenzposition des Magneten während einer ersten Iteration die Position des Magneten ist, der dem Referenzzeitpunkt zugeordnet ist;

f. Wiederholung der Schritte c) bis e), basierend auf der Schätzung aus Schritt e), durch Inkrementieren des Messzeitpunkts;

wobei das Verfahren so ist, dass in Schritt e) die Position ($r(t_n)$) des Magneten geschätzt wird aus:

- einer Schätzung der Position des Magneten zu einem Zeitpunkt ($t_{n-1}$, $t_{ref}$) vor dem Messzeitpunkt ($t_n$);
- einer Schätzung der Referenzposition, wobei diese Schätzung zu einem Zeitpunkt ($t_{n-1}$, $t_{ref}$) vor dem Messzeitpunkt ($t_n$) erfolgt;

und Schritt e) zum Messzeitpunkt ($t_n$) auch eine Aktualisierung der Schätzung der Referenzposition ($r_{ref}(t_n)$, $r_{ref}(t_{n,j})$) umfasst.

2. Verfahren nach Anspruch 1, bei dem Schritt e) eine Bestimmung eines Zustandsvektors ($x(t_n)$), bezogen auf den Messzeitpunkt ($t_n$), gemäß des Zustandsvektors zu einem Zeitpunkt vor dem Messzeitpunkt umfasst, wobei der vorherige Zeitpunkt ein Referenzzeitpunkt ($t_{ref}$, $t_{ref,j}$) oder ein Messzeitpunkt ($t_{n-1}$) ist, der einer vorherigen Iteration entspricht, wobei der Zustandsvektor Folgendes umfasst:

   - eine Schätzung der Position des Magneten zum Messzeitpunkt;
   - eine Schätzung mindestens einer Referenzposition des Magneten zum Messzeitpunkt;

   wobei der Zustandsvektor bei jeder Iteration aktualisiert wird.

3. Verfahren nach Anspruch 1 oder Anspruch 2, umfassend, nach Schritt e), einen Schritt e') zum Validieren entsprechender Schätzungen der Position des Magneten zum Messzeitpunkt ($r(t_n)$, $r(t_{n,j})$) und der Referenzposition ($r_{ref}(t_n)$, $r_{ref}(t_{n,j})$), wobei dieser Schritt die folgenden Teilschritte umfasst:

   i. Bestimmung einer Verschiebung ($V_b(t_n)$) des Magneten zwischen dem Messzeitpunkt ($t_n$) und dem Referenzzeitpunkt ($t_{ref}$, $t_{ref,j}$) durch Gewichtung zu jedem dieser Zeitpunkte einer Position jedes Magnetometers ($r_i$) um einen Gewichtungsfaktor ($k_i(t_n)$, $k_i(t_{ref})$), der vom Magnetfeldmodul ($B_i(t_n)$, $B_i(t_{ref})$) abhängig ist und vom Magnetometer ($10_i$) zu diesem Zeitpunkt gemessen wird;
   ii. Vergleich der in Teilschritt i) bestimmten Verschiebung mit einer nach den Schätzungen zum Messzeitpunkt ($t_n$) berechneten Verschiebung ($V_r(t_n)$) der Magnetposition ($r(t_n)$) und der Referenzposition ($r_{ref}(t_n)$, $r_{ref}(t_{n,j})$).

4. Verfahren nach Anspruch 3, wobei der Teilschritt i) umfasst:

   - Bestimmung für jedes Magnetometer eines als momentan bezeichneten differentiellen Magnetfelds ($\Delta B_i{'}(t_n)$, $\Delta B_i{'}(t_{ref})$), das eine Abweichung zwischen dem Magnetfeld ($B_i(t_n)$, $B_i(t_{ref})$), das zu einem ersten Zeitpunkt gemessen wurde, und dem Magnetfeld ($B_i(t_{n-q})$, $B_i(t_{ref\pm q})$) darstellt, das zu einem zweiten Zeitpunkt gemessen wurde, wobei der zweite Zeitpunkt dem ersten Zeitpunkt nahe ist, wobei die Bestimmung durchgeführt wird, indem nacheinander ein erster Zeitpunkt betrachtet wird, der dem Messzeitpunkt ($t_n$) und dem Referenzzeitpunkt ($t_{ref}$) entspricht, um zu jedem dieser Zeitpunkte ein momentanes differentielles Magnetfeld ($\Delta B_i{'}(t_n)$, $\Delta B_i{'}(t_{ref})$) zu erhalten;
   - wobei die Bestimmung jedes Gewichtungsfaktors ($k_i(t_n)$, $k_i(t_{ref})$) zum Messzeitpunkt und zum Referenzzeitpunkt jeweils ausgehend vom momentanen differentiellen Magnetfeld ($\Delta B_i{'}(t_n)$, $\Delta B_i{'}(t_{ref})$) jeweils zum Messzeitpunkt und zum Referenzzeitpunkt durchgeführt wird.

5. Verfahren nach einem der vorhergehenden Ansprüche, wobei:

   - die Schritte a) und b) wiederholt werden, so dass eine Vielzahl von Referenzpositionen ($j$) verfügbar ist, wobei jeder Referenzposition zugeordnet ist:

     • ein Referenzzeitpunkt ($t_{ref,j}$);
     • eine Zuordnung der Magnetposition zum Referenzzeitpunkt ($r_{ref}(t_{ref,j})$);
     • eine Messung des Magnetfelds ($B_i(t_{ref,j})$) durch jedes Magnetometer ($10_i$) zum Referenzzeitpunkt;

   - Schritt d) die Berechnung mindestens eines differentiellen Magnetfelds ($\Delta B_{i,j}(t_n)$) aus mindestens einem Referenzmagnetfeld ($B_i(t_{ref,j})$) umfasst.

6. Verfahren nach Anspruch 5, in dem jeder Referenzposition ($j$) ein Gültigkeitsindikator ($V_j(t_n)$) zugeordnet ist, der die Berücksichtigung der Referenzposition zu jedem Messzeitpunkt ($t_n$) in den Schritten d) und e) bedingt.

7. Verfahren nach einem der Ansprüche 5 oder 6, wobei die Schritte a) und b) wiederholt werden, wenn die Anzahl von Referenzpositionen kleiner als eine vorbestimmte Anzahl (J) von Referenzpositionen ist.

8. Verfahren nach einem der Ansprüche 5 bis 7, wobei Schritt d) die Berechnung einer Vielzahl von differentiellen Magnetfeldern ($\Delta B_{i,j}(t_n)$) umfasst, die jeweils für jedes Magnetometer ($10_i$) eine Differenz zwischen dem in Schritt c) gemessenen Magnetfeld ($B_i(t_n)$) und jedem Referenzmagnetfeld ($B_i(t_{ref,j})$) darstellen.

9. Verfahren nach Anspruch 8, wobei:

- Schritt e) eine Vielzahl von sogenannten Zwischenschätzungen der Position ($r(t_{n,j})$) des Magneten zum Messzeitpunkt ($t_n$) umfasst, wobei jede Zwischenschätzung auf einer voneinander verschiedenen Referenzposition ($j$) basiert und die Position des Magneten ($r(t_n)$) zum Messzeitpunkt gemäß den Zwischenschätzungen ($r(t_{n,j})$) bestimmt wird;
- Schritt e) auch eine Aktualisierung der Schätzung zum Messzeitpunkt ($t_n$) jeder Referenzposition ($r_{ref}(t_{n,j})$) umfasst.

10. Verfahren nach Anspruch 9, bei dem in Schritt e) die Position des Magneten ($r(t_n)$) zum Messzeitpunkt ($t_n$) geschätzt wird:

- auf Grundlage eines Mittelwerts der Zwischenschätzungen ($r(t_{n,j})$);
- und/oder unter Berücksichtigung der am weitesten entfernten Referenzposition ($j$) oder einer Referenzposition jenseits eines vorbestimmten Abstands der Vielzahl von Zwischenschätzungen ($r(t_{n,j})$);
- oder für jede Referenzposition ($j$), die einem Gültigkeitsindikator ($V_j(t_n)$) zugeordnet ist, auf Grundlage einer gemäß des Gültigkeitsindikators ($V_j(t_n)$) ausgewählten Referenzposition, die ihm zugeordnet ist;
- oder durch sukzessives Berücksichtigen jeder Referenzposition.

11. Verfahren nach einem der vorhergehenden Ansprüche, wobei Schritt e) neben der Schätzung der Position ($r(t_n)$) des Magneten zu jedem Messzeitpunkt eine Schätzung einer Ausrichtung ($\theta(t_n)$) des Magneten zu diesem Zeitpunkt und/oder eine Schätzung von Komponenten eines magnetischen Moments des Magnettenzum Messzeitpunkt ($t_n$) umfasst.

12. Verfahren nach einem der vorhergehenden Ansprüche, wobei:

- Schritt d) zum Messzeitpunkt ($t_n$) eine Bestimmung eines durchschnittlichen differentiellen Magnetfelds ($\overline{\Delta B(t_n)}$) umfasst, das eine Differenz zwischen einem Mittelwert der von jedem Magnetometer ($10_i$) jeweils zum Messzeitpunkt ($t_n$) bzw. zum Referenzzeitpunkt ($t_{ref}$) gemessenen Magnetfelder darstellt;
- Schritt e) eine Berücksichtigung des durchschnittlichen differentiellen Magnetfelds ($\overline{\Delta B(t_n)}$) umfasst, dessen Bedingungen vom differentiellen Magnetfeld subtrahiert werden ($\Delta B_i(t_n)$, $\Delta B_{i,j}(t_n)$).

13. Verfahren nach Anspruch 12, wobei Schritt e) Folgendes umfasst:

- eine Schätzung des differentiellen Magnetfelds ($h(x(t_n|t_{n-1}))$), das von jedem Magnetometer ($10_i$) zum Messzeitpunkt ($t_n$) gemessen wurde, sowie eine Bestimmung eines Mittelwerts ($\overline{h(x(t_n|t_{n-1}))}$) der Schätzungen;
- eine Berücksichtigung des Mittelwerts ($\overline{h(x(t_n|t_{n-1}))}$) der Schätzungen der einzelnen von jedem Magnetometer ($10_i$) gemessenen differentiellen Magnetfelder, deren Bedingungen von der Schätzung des differentiellen Magnetfelds ($h(x(t_n|t_{n-1}))$) subtrahiert werden, das zum Messzeitpunkt ($t_n$) von jedem Magnetometer ($10_i$) gemessen wird.

14. Verfahren nach einem der vorhergehenden Ansprüche, wobei Schritt e) die Bestimmung eines Zustandsvektors ($x_n$) in Bezug auf den Messzeitpunkt ($t_n$) umfasst, wobei dieser Zustandsvektor gemäß des Zustandsvektors zu einem Zeitpunkt vor dem Messzeitpunkt bestimmt wird und der Zeitpunkt vor der Messung der Referenzzeitpunkt ($t_{n-1}$) oder ein Zeitpunkt ist, der einer vorherigen Iteration ($t_{ref}$) entspricht, wobei der Zustandsvektor die Position des Magneten zum Messzeitpunkt umfasst.

15. Verfahren nach Anspruch 14, wobei Schritt e) Folgendes umfasst:

- eine Schätzung des Zustandsvektors zum Messzeitpunkt, basierend auf einem Zustandsvektor in Bezug auf den Zeitpunkt vor der Messung;
- eine Aktualisierung des Zustandsvektors zum Messzeitpunkt auf Grundlage des differentiellen Magnetfelds ($\Delta B_i(t_n)$, $\Delta B_{i,j}(t_n)$), das in Schritt d) bestimmt wurde.

16. Vorrichtung (1) zur Lokalisierung eines beweglichen Magneten (15), wobei der Magnet in Bezug auf eine Anordnung von Magnetometern ($10i$) bewegt werden kann, wobei jedes Magnetometer in der Lage ist, zu unterschiedlichen

Messzeitpunkten ($t_n$) eine Messung eines Magnetfelds ($\boldsymbol{B_i}(t_n)$, $\boldsymbol{B_i}(t_{ref})$), das von dem Magneten erzeugt wird, entlang mindestens einer Messachse ($x_i$, $y_i$, $z_i$) zu liefern, wobei die Vorrichtung einen Prozessor umfasst, der konfiguriert ist, um zu jedem Messzeitpunkt die von jedem Magnetometer gelieferten Messungen zu empfangen und das Verfahren nach den Ansprüchen 1 bis 15 durchzuführen, um eine Position des Magneten $r(t_n)$ zu jedem Messzeitpunkt zu schätzen.

**Claims**

1. Method for estimating a position ($r(t_n)$) of a magnet (15), said magnet being moved relative to a magnetometer array comprising a plurality of magnetometers ($10_i$), each magnetometer being able to measure a magnetic field ($B_i$) generated by said magnet along at least one measurement axis ($x_i,y_i,z_i$), the method including the following steps:

   a) measuring, with each magnetometer, a reference magnetic field ($\boldsymbol{B_i}(t_{ref})$, $\boldsymbol{B_i}(t_{ref,j})$) at a reference time ($t_{ref}$, $t_{ref,j}$);
   b) assigning a reference position ($\boldsymbol{r_{ref}}(t_{ref})$, $\boldsymbol{r_{ref}}(t_{ref,j})$) to the magnet at said reference time, the reference position being assigned to an arbitrary position or to an estimation of the position of the magnet at the reference time;
   c) measuring a magnetic field ($\boldsymbol{B_i}(t_n)$) generated by said magnet with each magnetometer ($10_i$), at a measurement time ($t_n$) subsequent to the reference time;
   d) calculating a differential magnetic field ($\Delta\boldsymbol{B_i}(t_n),\Delta\boldsymbol{B_{i,j}}(t_n)$) representing a difference, for each magnetometer ($10_i$), between the magnetic field ($\boldsymbol{B_i}(t_n)$) measured in step c) and the reference magnetic field ($\boldsymbol{B_i}(t_{ref}),\boldsymbol{B_{i,j}}(t_{ref,j})$) measured in step a);
   e) on the basis of each differential magnetic field ($\Delta\boldsymbol{B_i}(t_n),\Delta\boldsymbol{B_{i,j}}(t_n)$) and of an estimation of said reference position ($\boldsymbol{r_{ref}}(t_{ref})$, $\boldsymbol{r_{ref}}(t_{ref,j})$, $\boldsymbol{r_{ref}}(t_{n-1})$, $\boldsymbol{r_{ref}}(t_{n-1,j})$), estimating a position ($r(t_n)$) of the magnet at the measurement time ($t_n$), the estimation being carried out by a recursive estimator, the reference position of the magnet being, in a first iteration, the position that was assigned to the magnet at the reference time; and
   f) reiterating steps c) to e) on the basis of the estimation obtained in step e), while incrementing the measurement time;

   the method being such that, in step e), said position ($r(t_n)$) of the magnet is estimated on the basis:

   - of an estimation of the position of the magnet at a time ($t_{n-1}$, $t_{ref}$) preceding the measurement time ($t_n$);
   - of an estimation of the reference position, this estimation being carried out at a time ($t_{n-1}$, $t_{ref}$) preceding the measurement time ($t_n$);

   step e) also comprising updating, at the measurement time ($t_n$), the estimation of the reference position ($\boldsymbol{r_{ref}}(t_n),\boldsymbol{r_{ref}}(t_{n,j})$).

2. Method according to Claim 1, wherein step e) includes determining a state vector ($\boldsymbol{x}(t_n)$) relating to the measurement time ($t_n$), depending on the state vector at a time preceding the measurement time, the preceding time being a reference time ($t_{ref}$, $t_{ref,j}$) or a measurement time ($t_{n-1}$) corresponding to a preceding iteration, the state vector including:

   - an estimation of the position of the magnet at the measurement time;
   - an estimation, at the measurement time, of at least one reference position of the magnet;

   the state vector being brought up to date on each iteration.

3. Method according to Claim 1 or Claim 2, comprising, following step e), a step e') of validating the respective estimations of the position of the magnet at the measurement time ($r(t_n),r(t_{n,j})$) and of the reference position ($\boldsymbol{r_{ref}}(t_n),\boldsymbol{r_{ref}}(t_{n,j})$), this step including the following substeps:

   i) determining a movement ($\boldsymbol{V_b}(t_n)$) of the magnet between the measurement time ($t_n$) and the reference time ($t_{ref,tref,j}$), a position of each magnetometer ($r_i$) being weighted, at each of these times, by a weighting factor ($k_i(t_n)$, $k_i(t_{ref})$) that is dependent on the modulus of the magnetic field ($\boldsymbol{B_i}(t_n)$, $\boldsymbol{B_i}(t_{ref})$) measured by said magnetometer ($10_i$) at said time;
   ii) comparing the movement determined in substep i) with a movement ($\boldsymbol{V_r}(t_n)$) calculated using the estimations, at the measurement time ($t_n$), of the position of the magnet ($r(t_n)$) and of the reference position ($\boldsymbol{r_{ref}}(t_n)$, $\boldsymbol{r_{ref}}(t_{n,j})$).

**4.** Method according to Claim 3, wherein the substep i) comprises:

- determining, for each magnetometer, a differential magnetic field called the instantaneous differential magnetic field ($\Delta B_i{}'(t_n)$, $\Delta B_i{}'(t_{ref})$), which represents a variation between the magnetic field ($B_i(t_n)$, $B_i(t_{ref})$) measured at a first time and the magnetic field ($B_i(t_{n-q})$, $B_i(t_{ref\pm q'})$) measured at a second time, said second time neighbouring said first time, said determination being carried out by considering, in succession, a first time corresponding to the measurement time ($t_n$) and to the reference time ($t_{ref}$), so as to obtain an instantaneous differential magnetic field ($\Delta B_i{}'(t_n)$, $\Delta B_i{}'(t_{ref})$) at each of these times,
- said determination of each weighting factor ($k_i(t_n), k_i(t_{ref})$), at the measurement time and at the reference time being carried out, respectively, on the basis of the modulus of the instantaneous differential magnetic field ($\Delta B_i{}'(t_n)$, $\Delta B_i{}'(t_{ref})$) at the measurement time and at the reference time, respectively.

**5.** Method according to any one of the preceding claims, wherein:

- steps a) and b) are repeated, such that a plurality of reference positions ($j$) are obtained, each reference position being associated with:

  - a reference time ($t_{ref,j}$);
  - the position assigned to the magnet at said reference time ($r_{ref}(t_{ref,j})$); and
  - the magnetic field ($B_i(t_{ref,j})$) measured by each magnetometer ($10_i$) at said reference time; and

- step d) includes calculating at least one differential magnetic field ($\Delta B_{i,j}(t_n)$) from at least one reference magnetic field ($B_i(t_{ref,j})$).

**6.** Method according to Claim 5, wherein with each reference position ($j$) a validity indicator ($V_j(t_n)$) is associated, whether or not said reference position is taken into account, at each measurement time ($t_n$), in steps d) and e), depending on said validity indicator.

**7.** Method according to either one of Claims 5 and 6, wherein steps a) and b) are repeated when the number of reference positions is smaller than a preset number ($J$) of reference positions.

**8.** Method according to any one of Claims 5 to 7, wherein step d) comprises calculating a plurality of differential magnetic fields ($\Delta B_{i,j}(t_n)$) that each represent a difference, for each magnetometer ($10_i$), between the magnetic field ($B_i(t_n)$) measured in step c) and each reference magnetic field ($B_i(t_{ref,j})$).

**9.** Method according to Claim 8, wherein:

- step e) comprises a plurality of estimations, called intermediate estimations, of the position ($r(t_{n,j})$) of said magnet at said measurement time ($t_n$), each intermediate estimation being based on a reference position ($j$) that differs from one to the next, the position of the magnet ($r(t_n)$) at said measurement time being determined depending on these intermediate estimations ($r(t_{n,j})$); and
- step e) also comprises updating the estimation, at the measurement time ($t_n$), of each reference position ($r_{ref}(t_{n,j})$).

**10.** Method according to Claim 9, wherein, in step e), the position $r(t_n)$ of the magnet at the measurement time ($t_n$) is estimated:

- from an average of said intermediate estimations ($r(t_{n,j})$);
- and/or considering the reference position ($j$) that is the furthest away or a reference position located beyond a preset distance from the plurality of intermediate estimations ($r(t_{n,j})$);
- or, each reference position ($j$) being associated with a validity indicator ($V_j(t_n)$), on the basis of a reference position that is selected depending on the validity indicator ($V_j(t_n)$) that is associated therewith;
- or by considering each reference position in succession.

**11.** Method according to any one of the preceding claims, wherein step e) includes, apart from an estimation of the position $r(t_n)$ of the magnet at each measurement time, an estimation of the orientation $\theta(t_n)$ of the magnet at this time and/or an estimation of components of a magnetic moment of the magnet at the measurement time ($t_n$).

**12.** Method according to any one of the preceding claims, wherein:

- step d) comprises determining, at the measurement time ($t_n$), an average differential magnetic field ($\overline{\Delta\boldsymbol{B}(t_n)}$), which represents a difference between an average of the magnetic fields measured by each magnetometer ($10_i$) at the measurement time ($t_n$) and at the reference time ($t_{ref}$), respectively;
- step e) comprises taking into account said average differential magnetic field ($\overline{\Delta\boldsymbol{B}(t_n)}$), the terms of which are subtracted from the differential magnetic field ($\Delta\boldsymbol{B}_i(t_n)$), ($\Delta\boldsymbol{B}_{i,j}(t_n)$).

**13.** Method according to Claim 12, wherein step e) comprises:

- estimating the differential magnetic field ($h(x(t_n|t_{n-1}))$) measured, at the measurement time ($t_n$), by each magnetometer ($10_i$), and determining an average ($\overline{h(x(t_n|t_{n-1}))}$) of said estimations;
- taking into account said average ($\overline{h(x(t_n|t_{n-1}))}$) of the estimations of each differential magnetic field measured by each magnetometer ($10_i$), the terms of which are subtracted from said estimation of the differential magnetic field ($h(x(t_n|t_{n-1}))$) measured, at the measurement time ($t_n$), by each magnetometer ($10_i$).

**14.** Method according to any one of the preceding claims, wherein step e) includes determining a state vector ($x_n$) relating to the measurement time ($t_n$), this state vector being determined depending on said state vector at a time preceding the measurement time, the time preceding the measurement being the reference time ($t_{n-1}$) or a time corresponding to a preceding iteration ($t_{ref}$), the state vector including the position of the magnet at the measurement time.

**15.** Method according to Claim 14, wherein step e) includes:

- estimating the state vector at the measurement time, on the basis of a state vector relating to a time preceding the measurement; and
- updating the state vector at the measurement time, on the basis of the differential magnetic field ($\Delta\boldsymbol{B}_i(t_n)$, $\Delta\boldsymbol{B}_{i,j}(t_n)$) determined in step d).

**16.** Device (1) for locating a movable magnet (15), the magnet being able to be moved relative to a magnetometer array ($10_i$), each magnetometer being able to deliver, at various measurement times ($t_n$), a measurement of a magnetic field ($\boldsymbol{B}_i(t_n)$, ($\boldsymbol{B}_i(t_{ref})$)) produced by said magnet along at least one measurement axis ($x_i$, $y_i$, $z_i$), the device including a processor configured to receive, at each measurement time, the measurements delivered by each magnetometer, and to implement the method that is the subject matter of Claims 1 to 15, so as to estimate a position $\boldsymbol{r}(t_n)$ of the magnet at each measurement time.

**Fig. 1A**

**Fig. 1B**

$$\boxed{100}$$

$\downarrow \boldsymbol{B_i}(t_{ref})$

$$\boxed{110}$$

$\downarrow \boldsymbol{r_{ref}}(t_{ref})$

$$\boxed{120}$$

$\downarrow$

$$\boxed{130}$$

$\boldsymbol{x}(t_{n-1})$

$\downarrow \boldsymbol{B_i}(t_n)$

$$\boxed{140}$$

$\downarrow \Delta \boldsymbol{B_i}(t_n)\ \Delta \boldsymbol{B}(t_n)$

$$\boxed{150}$$

$\downarrow \boldsymbol{x}(t_n)$

$n = n + 1$

$$\boxed{160}$$

$\downarrow$

$\mathbf{r}(t_n), \boldsymbol{\theta}(t_n), \mathbf{r}_{ref}(t_n), \boldsymbol{\theta}_{ref}(t_n)$

**Fig. 2A**

**Fig. 2B**

160

$x(t_n)$

161

$\boldsymbol{b}(t_0), \boldsymbol{b}(t_n)$

162

$\boldsymbol{V_b}(t_n)\ \boldsymbol{V_r}(t_n)$

164

$Ind(t_n)$

**Fig. 3A**

**Fig. 3B**

**Fig. 3C**

**Fig. 4A**

$$\Delta B_{i,j}(t_n)$$

$$\Delta B(t_n)$$

$x(t_{n,j-1})$ → **251**

$G(t_{n,j-1})$

$x\left(t_n\,\middle|\,t_{n,j-1}\right), G\left(t_n\,\middle|\,t_{n,j-1}\right)$

**252** ← $h$

$y(t_{n,j}), S(t_{n,j})$

**253**

$K(t_{n,j})$

**254**

$x(t_{n,j}), G(t_{n,j})$

**255**

$j = j + 1$

$\mathbf{r}(t_n), \boldsymbol{\theta}(t_n), \mathbf{r}_{ref}(t_n, j)$

**Fig. 4B**

**EP 3 360 031 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013144337 A
- WO 2009007210 A